# EUROPEAN PATENT APPLICATION

(11) **EP 4 380 325 A1**
(43) Date of publication of application: **05.06.2024**
(21) Application number: 22849939.8
(22) Date of filing: 29.07.2022
(51) Int. Cl.: H05K 3/38, H05K 3/28, H05K 3/46, H01L 23/522

(54) **CIRCUIT BOARD AND SEMICONDUCTOR PACKAGE COMPRISING SAME**

(30) Priority: 29.07.2021 KR 20210100172; 30.07.2021 KR 20210100979
(71) Applicant: LG INNOTEK CO., LTD., Seoul 07796 (KR)
(72) Inventor: KWON, Myung Jae, Seoul 07796 (KR); NAM, Sang Hyuck, Seoul 07796 (KR); YEO, Ki Su, Seoul 07796 (KR); YOO, Chang Woo, Seoul 07796 (KR)
(74) Representative: Plasseraud IP
(86) International application number: PCT/KR2022/011239
(87) International publication number: WO 2023/008966

(57) **Abstract**

A circuit board according to an embodiment includes a first insulating layer including an upper and lower surface; and a first circuit pattern embedded at the upper surface of the first insulating layer, wherein the upper surface of the first insulating layer includes a portion that does not overlap the first circuit pattern in a vertical direction, and the portion of the upper surface of the first insulating layer has a step.

## Description

### [Technical Field]

An embodiment relates to a circuit board and a semiconductor package comprising the same.

### [Background Art]

As miniaturization, weight reduction, and integration of an electronic component are accelerated, a line width of a circuit has been miniaturized. In particular, as a design rule of a semiconductor chip is integrated on a nanometer scale, a circuit line width of a package substrate or a printed circuit board on which the semiconductor chip is mounted has been miniaturized to several micrometers or less.

Various methods have been proposed in order to increase the degree of circuit integration of the printed circuit board, that is, to reduce the circuit line width. For the purpose of preventing loss of the circuit line width in an etching step for forming a pattern after copper plating, a semi-additive process (SAP) method and a modified semi-additive process (MSAP) have been proposed.

Then, an embedded trace substrate (hereinafter referred to as "ETS") method for embedding a copper foil in an insulating layer in order to implement a fine circuit pattern has been used in the industry. In the ETS method, instead of forming a copper foil circuit on a surface of the insulating layer, the copper foil circuit is manufactured in an embedded form in the insulating layer, and thus there is no circuit loss due to etching and it is advantageous for miniaturizing the circuit pitch.

Meanwhile, in order to satisfy recent wireless data traffic demands, efforts are being made to develop improved 5G (5th generation) communication systems or pre-5G communication systems. Here, the 5G communication system uses ultra-high frequency (mm-Wave) bands (sub 6 GHz, 28 GHz, 38 GHz or higher frequencies) to achieve high data rates.

In this 5G communication system, multiple substrates (for example, an antenna substrate, an antenna feed substrate, a transceiver substrate, and a baseband substrate) are integrated into one compact unit. Accordingly, a circuit board applied to the 5G communication system must integrate various boards into one small device, and for this reason, miniaturization of circuit patterns is more important.

However, in conventional circuit boards, there is a problem in that it is difficult to form a line width and spacing of traces of the circuit pattern to 10um or less due to limitations in a process of manufacturing.

Furthermore, conventionally, a embedded pattern formed in an outermost layer of the ETS structure as described above cannot be subjected to AOI (Automatic Optical Inspection) inspection immediately after the embedded pattern is formed. That is, removal of a seed layer used for plating the embedded pattern is performed last in a process for manufacturing the circuit board after both a process of forming the circuit pattern and a process of laminating the insulating layer are completed. This is because the AOI cannot proceed because no distinction is made between the seed layer and the embedded pattern before the seed layer is removed.

In addition, when the AOI is performed after the seed layer used for plating the embedded pattern is removed, there is a problem that normal inspection is not possible for a side surface and a lower surface embedded in the insulating layer among upper, side, and lower surfaces of the embedded pattern.

### [Disclosure]

### [Technical Problem]

The embodiment provides a circuit board capable of miniaturizing circuit patterns and a semiconductor package including the same.

Additionally, the embodiment provides a circuit board capable of improving adhesion between an insulating layer and a protective layer and a semiconductor package including the same.

Additionally, the embodiment provides a circuit board that can minimize skin effects on circuit patterns and a semiconductor package including the same.

The embodiment provides a circuit board, a semiconductor package, and a method for inspecting the same that enable AOI even for a pattern (ETS pattern) embedded in an insulating layer.

Additionally, the embodiment provides a circuit board, a semiconductor package, and a method for inspecting the same that can improve inspection precision and inspection efficiency for a embedded pattern of the ETS structure.

Additionally, the embodiment provides a circuit board including a circuit pattern with different surface roughness (Ra) on upper, side, and lower surfaces, a semiconductor package, and a method for inspecting the same.

Additionally, the embodiment provides a circuit board, a semiconductor package, and an inspection method including the same that can improve the electrical reliability of an ETS pattern having a structure embedded in an insulating layer.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A circuit board according to an embodiment comprises a first insulating layer including an upper and lower surface; and a first circuit pattern embedded at the upper surface of the first insulating layer, wherein the upper surface of the first insulating layer includes a portion that does not overlap the first circuit pattern in a vertical direction, and wherein the portion of the upper surface of the first insulating layer has a step.

In addition, the portion of the first insulating layer includes a concave portion whose height decreases as it moves away from the first circuit pattern along a horizontal direction.

In addition, at least a portion of the first insulating layer is located higher than an upper surface of the first circuit pattern.

In addition, a centerline surface roughness (Ra) of the upper surface of the first insulating layer is different from a centerline surface roughness (Ra) of an upper surface of the first circuit pattern.

In addition, the centerline surface roughness (Ra) of the upper surface of the first insulating layer ranges between 0.01 um and 0.5um.

In addition, the first insulating layer is an uppermost insulating layer disposed on an uppermost side among a plurality of insulating layers, and wherein at least a portion of the upper surface of the first circuit pattern does not overlap in a vertical direction with the upper surface of the first insulating layer.

In addition, the first insulating layer includes a cavity that overlaps the first circuit pattern in a vertical direction, wherein the cavity includes an inner surface in contact with a side surface of the first circuit pattern, and a bottom surface in contact with a lower surface of the first circuit pattern, wherein a centerline surface roughness (Ra) of the upper surface of the first insulating layer is different from a centerline surface roughness (Ra) of the inner surface of the cavity and a centerline surface roughness (Ra) of the bottom surface of the cavity.

In addition, the centerline surface roughness (Ra) of the inner surface of the cavity is the same as the centerline surface roughness (Ra) of the bottom surface of the cavity.

In addition, the centerline surface roughness (Ra) of the upper surface of the first insulating layer is smaller than the centerline surface roughness (Ra) of the inner surface of the cavity and the centerline surface roughness (Ra) of the bottom surface of the cavity.

In addition, a centerline surface roughness (Ra) of the upper surface of the first insulating layer is smaller than a centerline surface roughness (Ra) of a lower surface of the first insulating layer.

In addition, the circuit board further comprises a second circuit pattern disposed at a lower surface of the first insulating layer; and a second insulating layer disposed at a lower surface of the first insulating layer and covering the second circuit pattern.

In addition, the centerline surface roughness (Ra) of the upper surface of the first insulating layer is smaller than at least one of a centerline surface roughness (Ra) of a side surface of the second circuit pattern and a centerline surface roughness (Ra) of a lower surface of the second circuit pattern.

In addition, the circuit board includes a first protective layer disposed on an upper surface of the first insulating layer and having an opening that overlaps at least a portion of the upper surface of the first circuit pattern in a vertical direction, and wherein the first protective layer fills the concave portion of the upper surface of the first insulating layer.

In addition, a centerline surface roughness (Ra) of a lower surface of the first protective layer satisfies a range of 0.01 um to 0.5um.

In addition, the first circuit pattern includes a trace, and a line width of the trace and a spacing between neighboring traces satisfies a range of 2um to 8um.

Meanwhile, the package substrate according to the embodiment comprises a first insulating layer including an upper surface and a lower surface, and including a cavity (C)oncave from the upper surface toward the lower surface; a first circuit pattern disposed in the cavity of the first insulating layer; a connection part disposed on an upper surface of the first circuit pattern; a chip disposed on the connection part; and a molding layer covering the chip, wherein the first insulating layer is an uppermost insulating layer disposed at an uppermost side among a plurality of insulating layers, the first circuit pattern is disposed in the cavity of the first insulating layer and does not vertically overlap the upper surface of the first insulating layer, the first insulating layer includes an inner surface of the cavity in contact with a side surface of the first circuit pattern, and a bottom surface of the cavity that contacts a lower surface of the first circuit pattern, a centerline surface roughness (Ra) of the upper surface of the first insulating layer is different from a centerline surface roughness (Ra) of the upper surface of the first circuit pattern, a centerline surface roughness (Ra) of the inner surface of the cavity, and a centerline surface roughness (Ra) of the bottom surface of the cavity, and wherein the centerline surface roughness (Ra) of the upper surface of the first insulating layer ranges from 0.01um to 0.5um.

A circuit board according to an embodiment comprises a first insulating layer; and a first circuit pattern partially embedded in the first insulating layer, wherein a side surface of the first circuit pattern has a first centerline surface roughness in a range of 0.05um to 0.6um, and a lower surface of the first circuit pattern has a second centerline surface roughness that is different from the first centerline surface roughness.

In addition, the first insulating layer is an insulating layer disposed at an uppermost side among a plurality of insulating layers, and the first circuit pattern is a circuit pattern disposed on the uppermost side among the circuit patterns disposed on the plurality of insulating layers.

In addition, an upper surface of the first circuit pattern does not overlap the upper surface of the first insulating layer in a vertical direction.

In addition, the second centerline surface roughness of the lower surface of the first circuit pattern is greater than the first centerline surface roughness of the side surface of the first circuit pattern.

In addition, the second centerline surface roughness of the lower surface of the first circuit pattern has a range between 110% and 170% of the first centerline surface roughness of the side surface of the first circuit pattern.

In addition, the upper surface of the first circuit pattern has a third centerline surface roughness that is different from the side and lower surfaces of the first circuit pattern.

In addition, the third centerline surface roughness is smaller than the first and second centerline surface roughness.

In addition, the circuit board further comprises a second circuit pattern disposed at the lower surface of the first insulating layer, and wherein side and lower surfaces of the second circuit pattern have the same fourth centerline surface roughness.

In addition, the fourth centerline surface roughness is the same as the first centerline surface roughness.

In addition, the fourth centerline surface roughness satisfies a range between 97% and 103% of the first centerline surface roughness.

In addition, the fourth centerline surface roughness is smaller than the second centerline surface roughness.

In addition, a side surface of the first circuit pattern is entirely covered by the first insulating layer.

Meanwhile, a package substrate according to the embodiment comprises a first insulating layer; a first circuit pattern partially embedded in the first insulating layer; a connection part disposed on an upper surface of the first circuit pattern; a chip disposed on the connection part; and a molding layer covering the chip, wherein a side surface of the first circuit pattern has a first centerline surface roughness in a range of 0.05um to 0.6um, a lower surface of the first circuit pattern has a second centerline surface roughness that is greater than the first centerline surface roughness, wherein an upper surface of the first circuit pattern has a third centerline surface roughness that is smaller than the first and second centerline surface roughness.

In addition, the chip includes first and second chips spaced apart in a vertical or horizontal direction, and wherein the first chip includes a central processor (CPU), and the second chip includes a graphics processor (GPU).

Meanwhile, a method for inspecting the circuit board according to the embodiment comprises preparing a carrier board including a carrier insulating layer and a carrier metal layer provided at a lower surface of the carrier insulating layer, forming a first dry film on a lower surface of the carrier metal layer including an opening that overlaps a first circuit pattern formation region in a vertical direction; forming a first circuit pattern to fill the opening of the first dry film by electroplating the carrier metal layer as a seed layer; soft-etching a lower surface of the first circuit pattern, and performing AOI (Automatic Optical Inspection) on the soft-etched lower surface of the first circuit pattern.

### [Advantageous Effects]

The circuit board of the embodiment includes a first insulating layer and a first circuit pattern. The first insulating layer is an uppermost insulating layer, and the first circuit pattern is an uppermost circuit pattern disposed on an upper surface of the uppermost insulating layer. At this time, the first circuit pattern is embedded in the first insulating layer. For example, at least a portion of an upper surface of the first circuit pattern does not overlap an upper surface of the first insulating layer in the vertical direction. At this time, the upper surface of the first insulating layer in the embodiment has a centerline surface roughness (Ra) in a range of 0.01um to 0.5um. And, the centerline surface roughness of the upper surface of the first insulating layer corresponds to a centerline surface roughness of a sputtering layer used as the seed layer of the first circuit pattern. At this time, if the centerline surface roughness (Ra) of the seed layer of the first circuit pattern exceeds 0.6um and the centerline surface roughness (Ra) of the upper surface of the first insulating layer accordingly exceeds 0.6um, there is a spaced portion between the dry film and the seed layer, and accordingly, it is difficult to refine a line width and spacing of the first circuit pattern to 10 µm or less. In contrast, the embodiment allows the centerline surface roughness (Ra) of the seed layer and the centerline surface roughness (Ra) of the upper surface of the first insulating layer to be in a range of 0.01um to 0.5um. Accordingly, the embodiment can increase a contact area between the seed layer and the dry film, thereby enabling miniaturization of the first circuit pattern. Accordingly, in the embodiment, the line width and spacing of the first circuit pattern can be formed to be 8um or less, and thus the circuit integration can be improved, and furthermore, a horizontal width and vertical thickness of the circuit board can be reduced.

Additionally, a step is formed at the upper surface of the first insulating layer in the embodiment. The step may be formed by removing a portion of the upper surface of the first insulating layer when removing the seed layer of the first circuit pattern. At this time, if the centerline surface roughness (Ra) of the upper surface of the first insulating layer is 0.5um or less, it is possible to miniaturize the first circuit pattern. However, it may cause problems with adhesion with the first protective layer, such as solder resist. Here, the embodiment forms a step such as a concave portion on the upper surface of the first insulating layer, and allows a first protective layer to fill the concave portion of the upper surface of the first insulating layer during formation of the first protective layer. Accordingly, the embodiment may increase a contact area between the upper surface of the first insulating layer and the lower surface of the first protective layer, and accordingly, the adhesion between the first insulating layer and the first protective layer can be improved.

In addition, the embodiment can improve the electrical reliability of the circuit board due to the step of the upper surface of the first insulating layer. Specifically, high integration of recent circuit boards is required, and accordingly, the line width and pitch of the first circuit pattern are becoming finer. In this case, it may not be possible to place an insulating layer, such as a protective layer, on the circuit board. At this time, space for arrangement of a connection part (e.g., solder) for attachment of a chip or interposer may not be secured on the first circuit pattern. As a result, a short circuit problem may occur where neighboring circuit patterns are connected due to the flow of the connection part. In contrast, the embodiment may block the flow of the connection part by a second portion of the upper surface of the first insulating layer. Furthermore, the embodiment may increase a length of the upper surface of the first insulating layer by the second portion, as a result, even if the connection part flows, it can be prevented from contacting neighboring circuit patterns.

In addition, the side and lower surfaces of the first circuit pattern in the embodiment may have different centerline surface roughness (Ra). For example, the lower surface of the first circuit pattern may have a centerline surface roughness (Ra) greater than a centerline surface roughness of the side surface of the first circuit pattern. This may be due to an additional soft etching process performed during the forming process of the first circuit pattern to perform an AOI on the lower surface of the first circuit pattern. Accordingly, the embodiment may allow AOI to be performed on the lower surface of the first circuit pattern before the seed layer of the first circuit pattern is removed and after the first circuit pattern is formed. Accordingly, the AOI accuracy of the first circuit pattern can be improved and inspection efficiency can be improved.

### [Description of Drawings]

FIG. 1A is a view for explaining a method of manufacturing a circuit board according to a comparative example.
FIG. 1B is a view for explaining a problem in a method of manufacturing a circuit board of a comparative example.
FIG. 2A is a cross-sectional view illustrating a semiconductor package according to a first embodiment.
FIG. 2B is a cross-sectional view illustrating a semiconductor package according to a second embodiment.
FIG. 2C is a cross-sectional view illustrating a semiconductor package according to a third embodiment.
FIG. 2D is a cross-sectional view illustrating a semiconductor package according to a fourth embodiment.
FIG. 2E is a cross-sectional view illustrating a semiconductor package according to a fifth embodiment.
FIG. 2F is a cross-sectional view illustrating a semiconductor package according to a sixth embodiment.
FIG. 2G is a cross-sectional view illustrating a semiconductor package according to a seventh embodiment.
FIG. 3 is a view showing a circuit board according to a first embodiment.
FIG. 4A is an enlarged view of a region of FIG. 3.
FIG. 4B is a view showing a SAM photograph of a corresponding product in FIG. 4A.
FIG. 4C is a view for explaining a centerline surface roughness (Ra) of an upper surface of a first insulating layer in FIG. 4A.
FIG. 5 is a plan view of a first circuit pattern of FIG. 3.

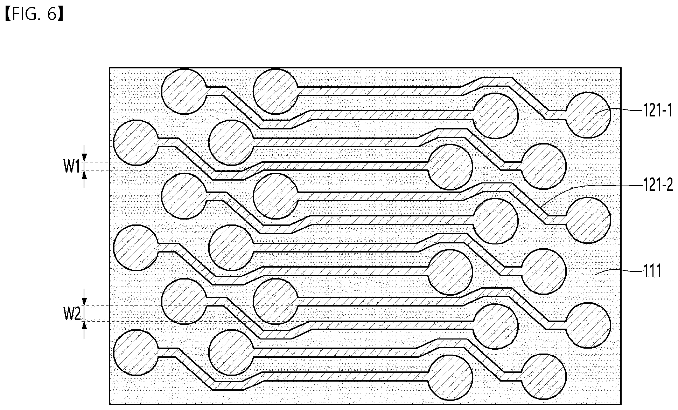

FIG. 6 is a diagram for explaining a layer structure of a circuit pattern of FIG. 3.
FIG. 7 is a view showing a package substrate according to an embodiment.
FIGS. 8A to 8M are views showing a method of manufacturing a circuit board shown in FIG. 3 in order of processes.
FIG. 9 is a view for explaining a surface roughness of a circuit board and a first circuit pattern according to a second embodiment.
FIG. 10 is a view for explaining a surface roughness of an inner circuit pattern or a second circuit pattern of FIG. 9.
FIG. 11 is a view for explaining a process of soft etching a lower surface of a first circuit pattern according to an embodiment.
FIGS. 12 to 25 are views showing a method of manufacturing the circuit board shown in FIG. 9 in order of processes.

### [Best Mode]

Hereinafter, the embodiment disclosed in the present specification will be described in detail with reference to the accompanying drawings, but the same or similar components are designated by the same reference numerals regardless of drawing numbers, and repeated description thereof will be omitted. The component suffixes "module" and "part" used in the following description are given or mixed together only considering the ease of creating the specification, and have no meanings or roles that are distinguished from each other by themselves. In addition, in describing the embodiments disclosed in the present specification, when it is determined that detailed descriptions of a related well-known art unnecessarily obscure gist of the embodiments disclosed in the present specification, the detailed description thereof will be omitted. Further, the accompanying drawings are merely for facilitating understanding of the embodiments disclosed in the present specification, the technological scope disclosed in the present specification is not limited by the accompanying drawings, and it should be understood as including all modifications, equivalents and alternatives that fall within the spirit and scope of the present invention.

It will be understood that, although the terms "first," "second," etc. may be used herein to describe various elements, these elements should not be limited by these terms. These terms are only used to distinguish one element from another.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (i.e., "between" versus "directly between," "adjacent" versus "directly adjacent," etc.).

As used herein, the singular forms "a," "an" and "the" are intended to include the plural forms as well, unless the context clearly indicates otherwise.

It will be further understood that the terms "comprises," "comprising," "includes" and/or "including," when used herein, specify the presence of stated features, integers, steps, operations, elements, and/or components, but do not preclude the presence or addition of one or more other features, integers, steps, operations, elements, components, and/or groups thereof.

Hereinafter, an embodiment of the present invention will be described in detail with reference to the attached drawings.

Before explaining the embodiments of the present invention, the problems of comparative examples will be explained.

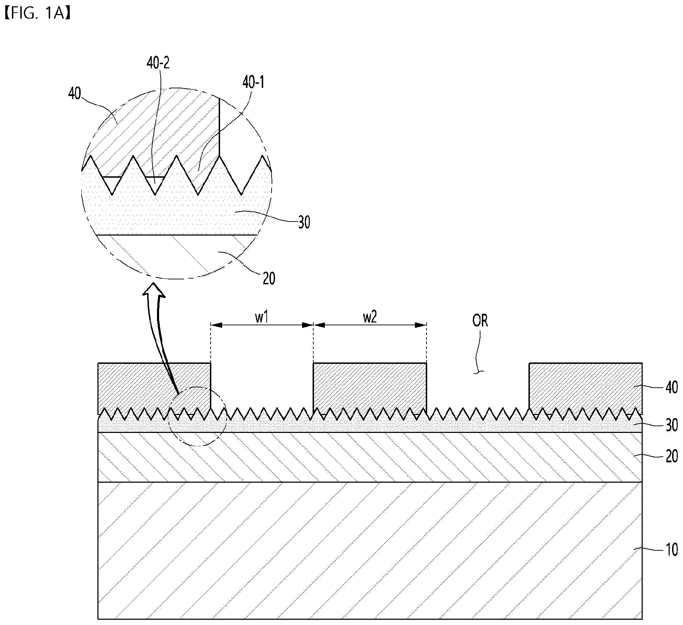

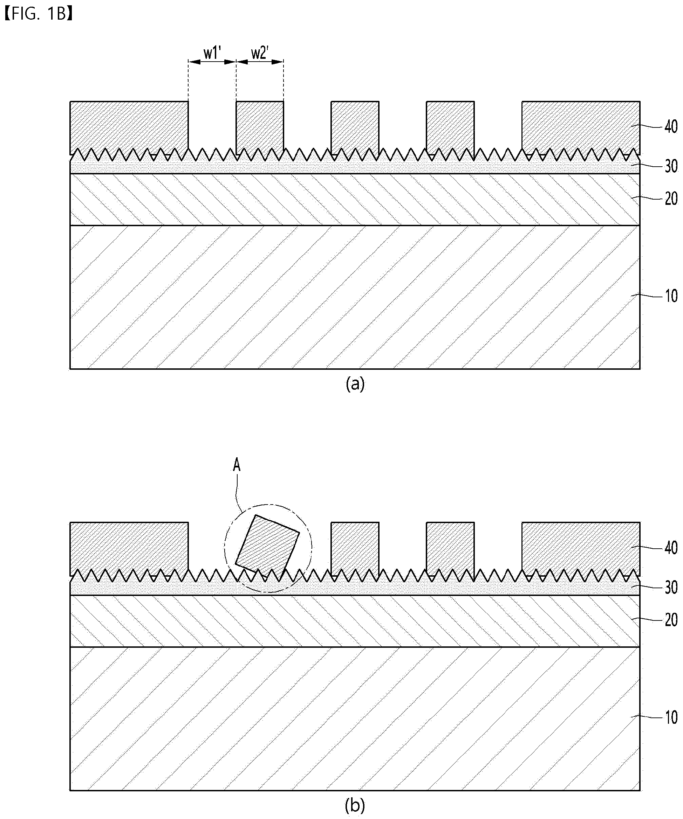

FIG. 1A is a view for explaining a method of manufacturing a circuit board according to a comparative example, and FIG. 1B is a view for explaining a problem in a method of manufacturing a circuit board of a comparative example.

Referring to FIGS. 1A and 1B, a circuit board of the comparative example is manufactured by an Embedded Trace Substrate (ETS) method for miniaturization of a circuit pattern.

In addition, a circuit pattern in the ETS method is formed by electroplating using a seed layer instead of forming a circuit pattern by etching a copper foil layer. For this reason, there is no change in the shape of the circuit pattern due to etching, and accordingly, the circuit pattern can be miniaturized.

In the comparative example, the ETS method is proceeded by performing a plating process on a carrier board or a support member to form a fine circuit pattern.

To this end, in the comparative example, a carrier board or a support member is prepared.

CCL (Copper Clad Laminate) is generally used for the carrier board or the support member.

For example, the carrier board or the support member includes a carrier insulating layer 10 and a carrier copper foil layer 20 disposed on the carrier insulating layer 10.

In addition, the carrier insulating layer 10 and the carrier copper foil layer 20 may be implemented using CCL.

In addition, the comparative example proceeds to form a circuit pattern by applying the dry film 40 directly on the carrier copper foil layer 20. Alternatively, the comparative example proceeds to form a circuit pattern by using a plating layer 30 after forming the additional plating layer 30 on the carrier copper foil layer 20.

At this time, the plating layer 30 is generally formed through a plating process. For example, the plating layer 30 is formed by an electrolytic plating or electroless plating process. Preferably, the plating layer 30 is generally formed through a chemical copper plating process.

Accordingly, an upper surface (for example, a surface in contact with the circuit pattern) of the plating layer 30 has a centerline surface roughness (Ra) corresponding to a plating condition in a plating process. For example, the upper surface of the plating layer 30 in the comparative example has a centerline surface roughness (Ra) exceeding 0.6um. For example, the upper surface of the plating layer 30 in the comparative example has a centerline surface roughness (Ra) exceeding 0.8um.

This is because, in order to improve the adhesion between the plating layer 30 and the dry film 40, a centerline surface roughness (Ra) above a certain level was given to the plating layer 30.

However, if the upper surface of the plating layer 30 has a centerline surface roughness (Ra) exceeding 0.6um as described above, it is difficult to form the width or spacing of the circuit pattern to 10um or less.

For example, if forming the dry film 40 on the upper surface of the plating layer 30, the lower surface of the dry film 40 includes a first portion 40-1 in contact with the upper surface of the plating layer 30 and a second portion 40-2 that is not in contact with the plating layer 30 (for example, is separated or spaced apart) due to a high centerline surface roughness (Ra) of the upper surface of the plating layer 30.

In addition, if a general circuit pattern having a line width or spacing exceeding 10um is formed on the plating layer 30, it is possible that a major problem (for example, a physical reliability problem in which the dry film 40 is separated from the plating layer 30) may not occur due to the non-contact second portion 40-2. However, the circuit pattern is becoming finer, and accordingly it causes a physical reliability problem due to the second portion 40-2.

For example, the dry film 40 disposed on the plating layer 30 includes a plurality of openings OR. Additionally, a width w1 of the opening OR corresponds to a width of the circuit pattern, and a separation distance w2 between the plurality of openings OR corresponds to the spacing of the circuit pattern.

In addition, if the width w1 of the opening OR exceeds 10um and the separation distance w2 between the openings OR exceeds 10um, the width of the portion corresponding to the separation distance w2 between the plurality of openings OR exceeds 10 µm, and accordingly, the problem of the dry film 40 being separated from the plating layer 30 may not occur.

However, if a width w1' of the opening OR is made smaller than 10um or a separation distance w2' between the openings (OR) is made smaller than 10um as shown in (a) of FIG. 1B, a bonding area between the dry film 40 and the plating layer 30 is reduced, and accordingly, problems may occur in adhesion between the dry film 40 and the plating layer 30 due to the second portion 40-2..

For example, a fact that the separation distance w2' between the openings is less than 10um means that the dry film 40 includes a region where the width of the region in contact with the upper surface of the plating layer 30 is smaller than 10 µm. In addition, if the width of the region in contact with the plating layer 30 in the dry film 40 is less than 10um, a bonding force between the dry film 40 and the plating layer 30 is reduced by the second portion 40-2 not in contact with the plating layer 30, and accordingly, the dry film 40 may include a region A that is separated from the plating layer 30 due to a decrease in adhesion.

Accordingly, in the comparative example, it was difficult to make the width of the opening OR of the dry film 40 or the separation distance between the openings smaller than 10um due to the centerline surface roughness (Ra) of the plating layer 30. Through this, it was difficult to refine the width and separation distance of the circuit pattern to 10um or less.

Accordingly, the embodiment allows reducing the centerline surface roughness (Ra) of the plating layer used as a seed layer in the process of electroplating the circuit pattern compared to the comparative example. Accordingly, the embodiment allows reducing the area of the non-contact region between the dry film and the plating layer, thereby enabling miniaturization of the circuit pattern.

However, even if the centerline surface roughness (Ra) of the plating layer is too small, problems may occur in the adhesion between the plating layer and the dry film. Accordingly, the embodiment allows the circuit pattern to be refined compared to the comparative example without problems with the adhesion between the plating layer and the dry film. To this end, the embodiment allows reducing the centerline surface roughness (Ra) of the plating layer compared to the comparative example.

### -Electronic device-

Before describing the embodiment, an electronic device to which the semiconductor package of the embodiment is applied will be briefly described. The electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor chip in the form of an integrated circuit (IC) in which hundreds to millions of devices are integrated in one chip. The semiconductor device may be a logic chip, a memory chip, or the like. The logic chip may be a central processor (CPU), a graphics processor (GPU), or the like. For example, the logic chip may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far.

The memory chip may be a stack memory such as HBM. The memory chip may also include a memory chip such as volatile memory (eg, DRAM), non-volatile memory (eg, ROM), flash memory, and the like.

On the other hand, a product group to which the semiconductor package of the embodiment is applied may be any one of CSP (Chip Scale Package), FC-CSP (Flip Chip-Chip Scale Package), FC-BGA (Flip Chip Ball Grid Array), POP (Package on Package) and SIP (System in Package), but is not limited thereto.

In addition, the electronic device may be a smart phone, a personal digital assistant, a digital video camera, a digital still camera, a vehicle, a high-performance server, a network system, computer, monitor, tablet, laptop, netbook, television, video game, smart watch, automotive, or the like. However, the embodiment is not limited thereto, and may be any other electronic device that processes data in addition to these.

Hereinafter, a semiconductor package including a circuit board according to an embodiment will be described. The semiconductor package of the embodiment may have various package structures including a circuit board to be described later. In addition, the circuit board in one embodiment may be a package substrate described below, and the circuit board in another embodiment may be an interposer described below.

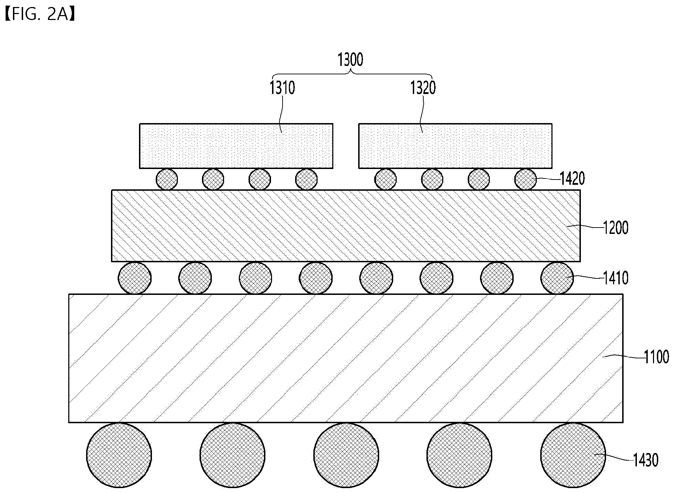

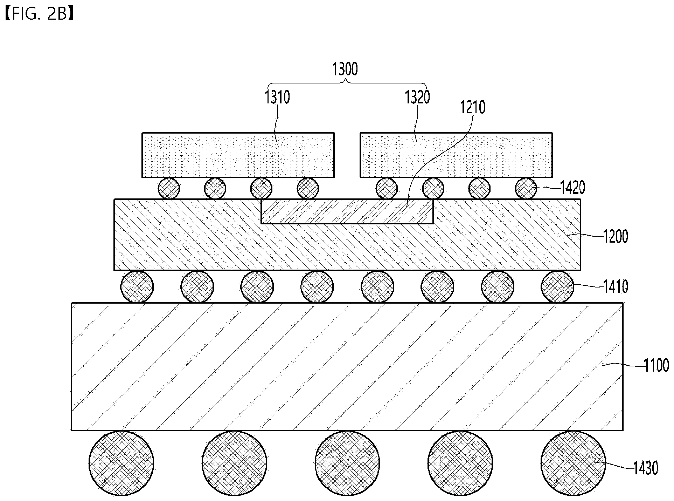

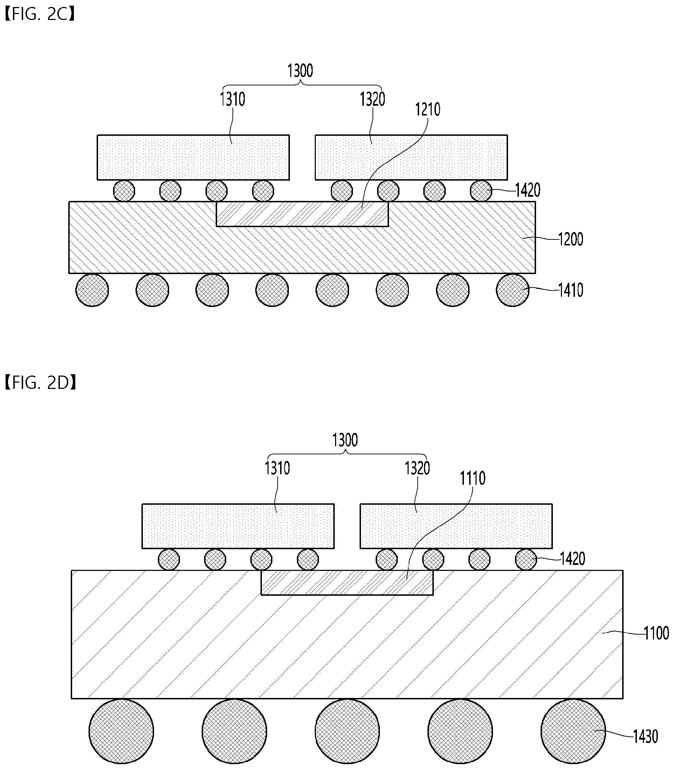

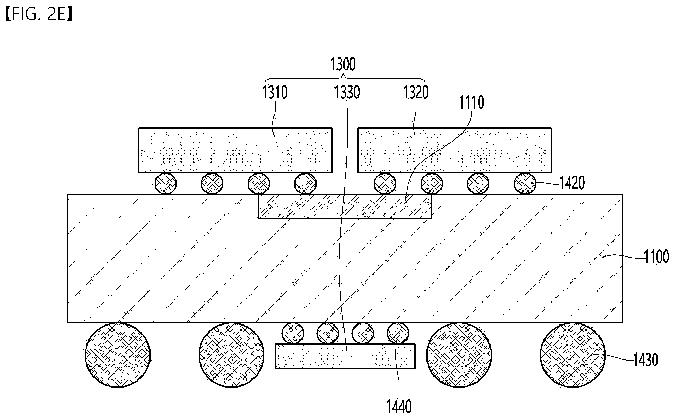

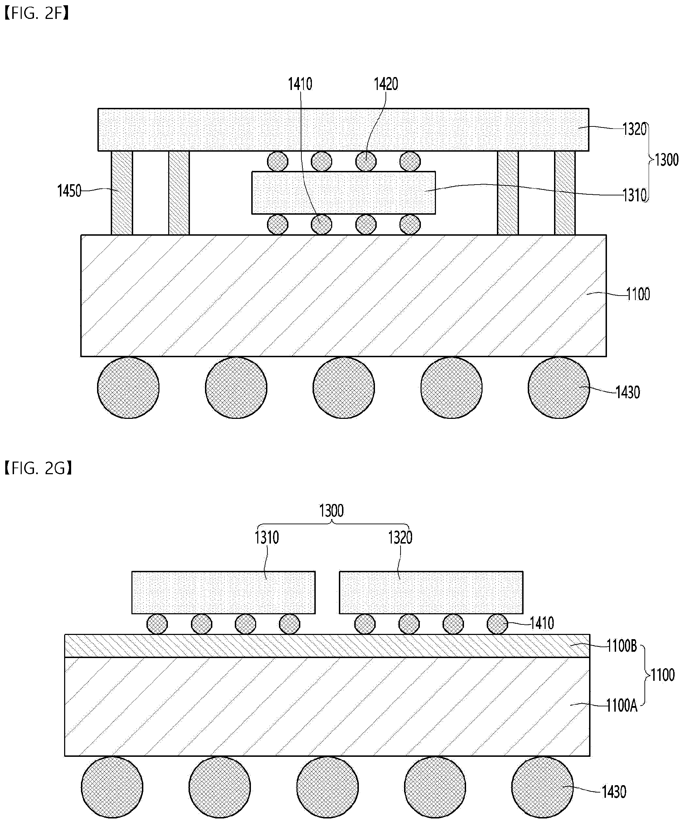

FIG. 2A is a cross-sectional view illustrating a semiconductor package according to a first embodiment, FIG. 2B is a cross-sectional view illustrating a semiconductor package according to a second embodiment, FIG. 2C is a cross-sectional view illustrating a semiconductor package according to a third embodiment, FIG. 2D is a cross-sectional view illustrating a semiconductor package according to a fourth embodiment, FIG. 2E is a cross-sectional view illustrating a semiconductor package according to a fifth embodiment, FIG. 2F is a cross-sectional view illustrating a semiconductor package according to a sixth embodiment, and FIG. 2G is a cross-sectional view illustrating a semiconductor package according to a seventh embodiment.

Referring to FIG. 2A, the semiconductor package according to the first embodiment may include a first circuit board 1100, a second circuit board 1200, and a semiconductor device 1300.

The first circuit board 1100 means a package substrate.

For example, the first circuit board 1100 may provide a space to which at least one external substrate is coupled. The external substrate may refer to a second circuit board 1200 coupled to the first circuit board 1100. Also, the external substrate may refer to a main board included in an electronic device coupled to a lower portion of the first circuit board 1100.

Also, although not shown in the drawing, the first circuit board 1100 may provide a space in which at least one semiconductor device is mounted.

The first circuit board 1100 includes at least one insulating layer, an electrode disposed on the at least one insulating layer, and a through portion passing through the at least one insulating layer.

A second circuit board 1200 is disposed on the first circuit board 1100.

The second circuit board 1200 may be an interposer. For example, the second circuit board 1200 may provide a space in which at least one semiconductor device is mounted. The second circuit board 1200 may be connected to the at least one semiconductor device 1300. For example, the second circuit board 1200 may provide a space in which the first semiconductor device 1310 and the second semiconductor device 1320 are mounted. The second circuit board 1200 may electrically connect the first and second semiconductor devices 1310 and 1320 and the first circuit board 1100 while electrically connecting the first semiconductor device 1310 and the second semiconductor device 1320. That is, the second circuit board 1200 may perform a horizontal connection function between a plurality of semiconductor devices and a vertical connection function between the semiconductor devices and the package substrate.

FIG. 2 illustrates that the first and second semiconductor devices 1310 and 1320 are disposed on the second circuit board 1200, but is not limited thereto. For example, one semiconductor device may be disposed on the second circuit board 1200, or alternatively, three or more semiconductor devices may be disposed.

The second circuit board 1200 may be disposed between the semiconductor device 1300 and the first circuit board 1100.

In an embodiment, the second circuit board 1200 may be an active interposer that functions as a semiconductor device. When the second circuit board 1200 functions as a semiconductor device, the package of the embodiment may have a structure in which a plurality of logic chips are mounted on the first circuit board 1100 in a vertically stacked structure. In addition, a first logic chip corresponding to the active interposer among the logic chips may perform a signal transfer function between the second logic chip disposed thereon and the first circuit board 1100 while functioning as a corresponding logic chip.

According to another embodiment, the second circuit board 1200 may be a passive interposer. For example, the second circuit board 1200 may function as a signal relay between the semiconductor device 1300 and the first circuit board 1100. For example, a number of terminals of the semiconductor device 1300 is gradually increasing due to 5G, Internet of Things (IOT), increased image quality, and increased communication speed. That is, the number of terminals provided in the semiconductor device 1300 increases, thereby reducing the width of the terminals or an interval between the plurality of terminals. In this case, the first circuit board 1100 is connected to the main board of the electronic device. There is a problem in that the thickness of the first circuit board 1100 increases or the layer structure of the first circuit board 1100 becomes complicated in order for the electrodes provided on the first circuit board 1100 to have a width and an interval to be respectively connected to the semiconductor device 1300 and the main board. Accordingly, in the first embodiment, the second circuit board 1200 is disposed on the first circuit board 1100 and the semiconductor device 1300. In addition, the second circuit board 1200 may include electrodes having a fine width and an interval corresponding to the terminals of the semiconductor device 1300.

the semiconductor device 1300 may be an application processor (AP) chip including at least one of a central processor (CPU), a graphics processor (GPU), a digital signal processor, a cryptographic processor, a microprocessor and a microcontroller, or an analog-digital converter, an application-specific IC (ASIC), or the like, or a chip set comprising a specific combination of those listed so far. The memory chip may be a stack memory such as HBM. The memory chip may also include a memory chip such as volatile memory (e.g., DRAM), non-volatile memory (e.g., ROM), flash memory, and the like.

Meanwhile, the semiconductor package of the first embodiment may include a connection portion.

For example, the semiconductor package includes a first connection portion 1410 disposed between the first circuit board 1100 and the second circuit board 1200. The first connection portion 1410 electrically connects the second circuit board 1200 to the first circuit board 1100 while coupling them.

For example, the semiconductor package may include the second connection portion 1420 disposed between the second circuit board 1200 and the semiconductor device 1300. The second connection portion 1420 may electrically connect the semiconductor device 1300 to the second circuit board 1200 while coupling them.

The semiconductor package includes a third connection portion 1430 disposed on a lower surface of the first circuit board 1100. The third connection portion 1430 may electrically connect the first circuit board 1100 to the main board while coupling them.

At this time, the first connection portion 1410, the second connection portion 1420, and the third connection portion 1430 may electrically connect between the plurality of components by using at least one bonding method of wire bonding, solder bonding and metal-to-metal direct bonding.

That is, since the first connection portion 1410, the second connection portion 1420, and the third connection portion 1430 have a function of electrically connecting a plurality of components, when the metal-to-metal direct bonding is used, the connection portion of the semiconductor package may be understood as an electrically connected portion, not a solder or wire.

The wire bonding method may refer to electrically connecting a plurality of components using a conductive wire such as gold (Au). Also, the solder bonding method may electrically connect a plurality of components using a material containing at least one of Sn, Ag, and Cu. In addition, the metal-to-metal direct bonding method may refer to recrystallization by applying heat and pressure between a plurality of components without the presence of solder, wire, conductive adhesive, etc. and to directly bond between the plurality of components. In addition, the metal-to-metal direct bonding method may refer to a bonding method by the second connection portion 1420. In this case, the second connection portion 1420 may mean a metal layer formed between a plurality of components by the recrystallization.

Specifically, the first connection portion 1410, the second connection portion 1420, and the third connection portion 1430 may couple a plurality of components to each other by a thermal compression (TC) bonding method. The TC bonding may refer to a method of directly coupling a plurality of components by applying heat and pressure to the first connection portion 1410, the second connection portion 1420, and the third connection portion 1430.

In this case, at least one of the first circuit board 1100 and the second circuit board 1200 may include a protrusion provided in the electrode on the first connection portion 1410, the second connection portion 1420, and the third connection portion 1430 are disposed. The protrusion may protrude outward from the first circuit board 1100 or the second circuit board 1200.

The protrusion may be referred to as a bump. The protrusion may also be referred to as a post. The protrusion may also be referred to as a pillar. Preferably, the protrusion may refer to an electrode on which a second connection portion 1420 for coupling with the semiconductor device 1300 is disposed among the electrodes of the second circuit board 1200. That is, as a pitch of the terminals of the semiconductor device 1300 is reduced, a short circuit may occur in the second connection portions 1420 respectively connected to the terminals of the semiconductor device 1300. Accordingly, in the embodiment, the protrusion is included in the electrode of the second circuit board 1200 on which the second connection portion 1420 is disposed in order to reduce a volume of the second connection portion 1420. The protrusion may improve matching between the electrode of the second circuit board 1200 and the terminal of the semiconductor device 1300 and prevent diffusion of the second connection portion 1420.

Meanwhile, referring to FIG. 2B, the semiconductor package of the second embodiment is different from the semiconductor package of the first embodiment in that the connecting member 1210 is disposed on the second circuit board 1200. The connecting member 1210 may be referred to as a bridge substrate. For example, the connecting member 1210 may include a redistribution layer.

In an embodiment, the connecting member 1210 may be a silicon bridge. That is, the connecting member 1210 may include a silicon substrate and a redistribution layer disposed on the silicon substrate.

In another embodiment, the connecting member 1210 may be an organic bridge. For example, the connecting member 1210 may include an organic material. For example, the connecting member 1210 includes an organic substrate including an organic material instead of the silicon substrate.

The connecting member 1210 may be embedded in the second circuit board 1200, but is not limited thereto. For example, the connecting member 1210 may be disposed on the second circuit board 1200 to have a protruding structure.

Also, the second circuit board 1200 may include a cavity, and the connecting member 1210 may be disposed in the cavity of the second circuit board 1200.

The connecting member 1210 may horizontally connect a plurality of semiconductor devices disposed on the second circuit board 1200.

Referring to FIG. 2C, the semiconductor package according to the third embodiment includes a second circuit board 1200 and a semiconductor device 1300. In this case, the semiconductor package of the third embodiment has a structure in which the first circuit board 1100 is removed compared to the semiconductor package of the second embodiment.

That is, the second circuit board 1200 of the third embodiment may function as a package substrate while performing an interposer function.

The first connection portion 1410 disposed on the lower surface of the second circuit board 1200 may couple the second circuit board 1200 to the main board of the electronic device.

Referring to FIG. 2D, the semiconductor package according to the fourth embodiment includes a first circuit board 1100 and a semiconductor device 1300.

In this case, the semiconductor package of the fourth embodiment has a structure in which the second circuit board 1200 is removed compared to the semiconductor package of the second embodiment.

That is, the first circuit board 1100 of the fourth embodiment may function as an interposer connecting the semiconductor device 1300 and the main board while functioning as a package substrate. To this end, the first circuit board 1100 may include a connecting member 1110 for connecting the plurality of semiconductor devices. The connecting member 1110 may be a silicon bridge or an organic material bridge connecting a plurality of semiconductor devices.

Referring to FIG. 2E, the semiconductor package of the fifth embodiment further includes a third semiconductor device 1330 compared to the semiconductor package of the fourth embodiment.

To this end, a fourth connection portion 1440 is disposed on the lower surface of the first circuit board 1100.

In addition, a third semiconductor device 1330 may be disposed on the fourth connection portion1400. That is, the semiconductor package of the fifth embodiment may have a structure in which semiconductor devices are mounted on upper and lower sides, respectively.

In this case, the third semiconductor device 1330 may have a structure disposed on the lower surface of the second circuit board 1200 in the semiconductor package of FIG. 2C.

Referring to FIG. 2F, the semiconductor package according to the sixth embodiment includes a first circuit board 1100.

A first semiconductor device 1310 may be disposed on the first circuit board 1100. To this end, a first connection portion 1410 is disposed between the first circuit board 1100 and the first semiconductor device 1310.

In addition, the first circuit board 1100 includes a conductive coupling portion 1450. The conductive coupling portion 1450 may further protrude from the first circuit board 1100 toward the second semiconductor device 1320. The conductive coupling portion 1450 may be referred to as a bump or, alternatively, may also be referred to as a post. The conductive coupling portion 1450 may be disposed to have a protruding structure on an electrode disposed on an uppermost side of the first circuit board 1100.

A second semiconductor device 1320 is disposed on the conductive coupling portion 1450 of the first circuit board 1100. In this case, the second semiconductor device 1320 may be connected to the first circuit board 1100 through the conductive coupling portion 1450. In addition, a second connection portion 1420 may be disposed on the first semiconductor device 1310 and the second semiconductor device 1320.

Accordingly, the second semiconductor device 1320 may be electrically connected to the first semiconductor device 1310 through the second connection portion 1420.

That is, the second semiconductor device 1320 is connected to the first circuit board 1100 through the conductive coupling portion 1450, and is also connected to the first semiconductor device 1310 through the second connection portion 1420.

In this case, the second semiconductor device 1320 may receive a power signal through the conductive coupling portion 1450. Also, the second semiconductor device 1320 may transmit and receive a communication signal to and from the first semiconductor device 1310 through the second connection portion 1420.

The semiconductor package according to the sixth embodiment provides a power signal to the second semiconductor device 1320 through the conductive coupling portion 1450, thereby providing sufficient power for driving the second semiconductor device 1320. Accordingly, the embodiment may improve the driving characteristics of the second semiconductor device 1320. That is, the embodiment may solve the problem of insufficient power provided to the second semiconductor device 1320. Furthermore, in the embodiment, the power signal and the communication signal of the second semiconductor device 1320 are provided through different paths through the conductive coupling portion 1450 and the second connection portion 1420. Through this, the embodiment can solve the problem that the communication signal is lost due to the power signal. For example, the embodiment may minimize mutual interference between communication signals of power signals. Meanwhile, the second semiconductor device 1320 according to the sixth embodiment may have a POP structure and be disposed on the first circuit board 1100. For example, the second semiconductor device 1320 may be a memory package including a memory chip. In addition, the memory package may be coupled on the conductive coupling portion 1450. In this case, the memory package may not be connected to the first semiconductor device 1310.

Referring to FIG. 2G, the semiconductor package according to the seventh embodiment includes a first circuit board 1100, a first connection portion 1410, a first connection portion 1410, a semiconductor device 1300, and a third connection portion 1430.

In this case, the semiconductor package of the seventh embodiment is different from the semiconductor package of the fourth embodiment in that the first circuit board 1100 includes a plurality of substrate layers while the connecting member 1110 is removed.

The first circuit board 1100 includes a plurality of substrate layers. For example, the first circuit board 1100 may include a first substrate layer 1100A corresponding to a package substrate and a second substrate layer 1100B corresponding to a redistribution layer of the connecting member.

That is, in the first circuit board 1100, a second substrate layer 1100B corresponding to a redistribution layer is disposed on the first substrate layer 1100A.

In other words, the semiconductor package of the seventh embodiment includes the first substrate layer 1100A and the second substrate layer 1100B integrally formed. The material of the insulating layer of the second substrate layer 1100B may be different from the material of the insulating layer of the first substrate layer 1100A. For example, the material of the insulating layer of the second substrate layer 1100B may include a photocurable material. For example, the second substrate layer 1100B may be a photo imageable dielectric (PID). In addition, since the second substrate layer 1100B includes a photocurable material, it is possible to miniaturize the electrode. Accordingly, in the seventh embodiment, the second substrate layer 1100B may be formed by sequentially stacking an insulating layer of a photo-curable material on the first substrate layer 1100A and forming a miniaturized electrode on the insulating layer of the photo-curable material. Through this, the second substrate 1100B may be a redistribution layer including a miniaturized electrode.

Hereinafter, the circuit board of the embodiment will be described.

Before describing the circuit board of the embodiment, the circuit board described below may mean any one of a plurality of circuit boards included in the previous semiconductor package.

For example, in one embodiment, the circuit board described below may refer to the first circuit board 1100 shown in any one of FIGS. 2A to 2G. Additionally, the circuit board described below in another embodiment may refer to the second circuit board 1200 shown in any one of FIGS. 2A to 2G.

### - circuit board -

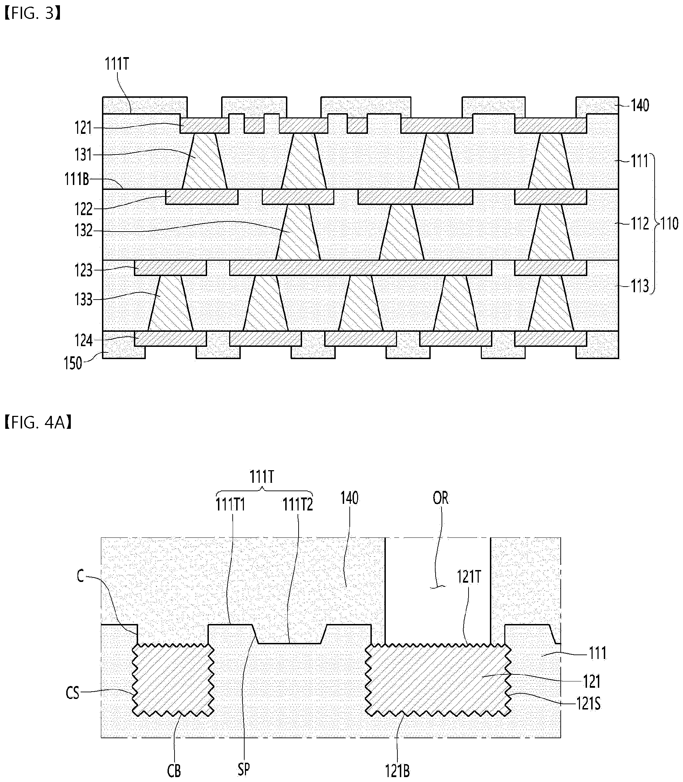

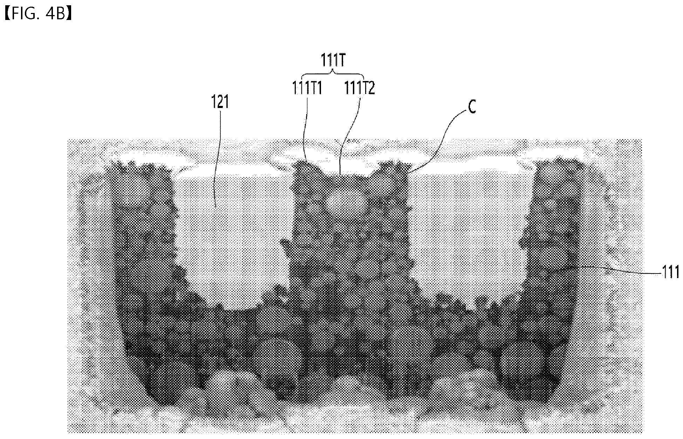

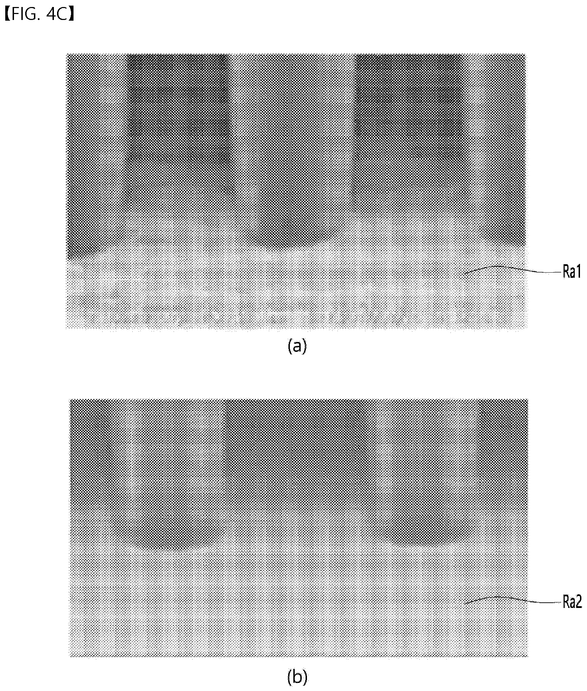

FIG. 3 is a view showing a circuit board according to a first embodiment, FIG. 4A is an enlarged view of a region of FIG. 3, FIG. 4B is a view showing a SAM photograph of a corresponding product in FIG. 4A, and FIG. 4C is a view for explaining a centerline surface roughness (Ra) of an upper surface of a first insulating layer in FIG. 4A.

Hereinafter, the circuit board according to an embodiment will be described in detail with reference to FIGS. 3, 4A, 4B, 4C and 5.

The circuit board of the embodiment provides a mounting space in which at least one chip can be mounted. The number of chips mounted on the circuit board of the embodiment may be one, alternatively may be two, or alternatively there may be three or more. For example, one processor chip may be mounted on the circuit board, alternatively, at least two processor chips having different functions may be mounted on the circuit board, alternatively, one memory chip may be mounted together with one processor chip, and alternatively, at least two processor chips having different functions and at least one memory chip may be mounted.

The circuit board includes an insulating layer 110. The insulating layer 110 has a structure of at least one layer. At this time, although FIG. 2 illustrates that the circuit board has a three-layer structure based on the number of layers of the insulating layer 110, but the embodiment is not limited thereto. For example, the circuit board may have a stacked structure of two or less layers based on the number of insulating layers 110, or alternatively, may have a stacked structure of four or more layers.

However, hereinafter, the circuit board will be described as having a three-layer structure based on the number of insulating layers 110 for convenience of explanation.

The insulating layer 110 may include a prepreg (PPG). The prepreg may be formed by impregnating a fiber layer in the form of a fabric sheet, such as a glass fabric woven with glass yarn, with an epoxy resin, and then performing thermocompression. However, the embodiment is not limited thereto, and the prepreg constituting the insulating layer 110 may include a fiber layer in the form of a fabric sheet woven with carbon fiber yarn.

The insulating layer 110 may include a resin and a reinforcing fiber disposed in the resin. The resin may be an epoxy resin, but is not limited thereto. The resin is not particularly limited to the epoxy resin, and for example, one or more epoxy groups may be included in the molecule, or alternatively, two or more epoxy groups may be included, or alternatively, four or more epoxy groups may be included. In addition, the resin of the insulating layer 110 may include a naphthalene group, for example, may be an aromatic amine type, but is not limited thereto. For example, the resin may be include a bisphenol A type epoxy resin, a bisphenol F type epoxy resin, a bisphenol S type epoxy resin, a phenol novolac type epoxy resin, an alkylphenol novolac type epoxy resin, a biphenyl type epoxy resin, an aralkyl type epoxy resin, dicyclopentadiene type epoxy resin, naphthalene type epoxy resin, naphthol type epoxy resin, epoxy resin of condensate of phenol and aromatic aldehyde having phenolic hydroxyl group, biphenyl aralkyl type epoxy resin, fluorene type epoxy resin resins, xanthene-type epoxy resins, triglycidyl isocyanurate, rubber-modified epoxy resins, phosphorous-based epoxy resins, and the like, and naphthalene-based epoxy resins, bisphenol A-type epoxy resins, and phenol novolac epoxy resins, cresol novolak epoxy resins, rubber-modified epoxy resins, and phosphorous-based epoxy resins. In addition, the reinforcing fiber may include glass fiber, carbon fiber, aramid fiber (eg, aramid-based organic material), nylon, silica-based inorganic material or titania-based inorganic material. The reinforcing fibers may be arranged in the resin to cross each other in a planar direction.

Meanwhile, the glass fiber, carbon fiber, aramid fiber (eg, aramid-based organic material), nylon, silica-based inorganic material or titania-based inorganic material may be used.

However, the embodiment is not limited thereto, and the insulating layer 110 may include other insulating materials.

For example, the insulating layer 110 may be rigid or may be flexible. For example, the insulating layer 110 may include glass or plastic. In detail, the insulating layer 110 may include chemically strengthened/semi-tempered glass such as soda lime glass or aluminosilicate glass, or strengthened or flexible plastic such as polyimide (PI), polyethylene terephthalate (PET), propylene glycol (PPG) and polycarbonate (PC), or sapphire. For example, the insulating layer 110 may include an optical isotropic film. For example, the insulating layer 110 may be includes COC (cyclic Olefin Copolymer), COP (Cyclic Olefin Polymer), photo isotropic polycarbonate (polycarbonate, PC), or photo isotropic polymethyl methacrylate (PMMA). For example, the insulating layer 110 may be formed of a material including an inorganic filler and an insulating resin. For example, the insulating layer 110 may be formed of a material including an inorganic filler and an insulating resin. For example, the insulating layer 110 may be formed of a thermosetting resin such as an epoxy resin, resins containing reinforcing materials such as inorganic fillers such as silica and alumina together with thermoplastic resins such as polyimide, specifically Ajinomoto Build-up Film (ABF), FR-4, Bismaleimide Triazine (BT), Photo Imageable Dielectric resin (PID), BT, or the like may be used.

The insulating layer 110 may include a first insulating layer 111, a second insulating layer 112, and a third insulating layer 113 from an uppermost side.

The first insulating layer 111, the second insulating layer 112, and the third insulating layer 113 may each have a thickness ranging from 5 µm to 80 µm. For example, the first insulating layer 111, the second insulating layer 112, and the third insulating layer 113 may have a thickness ranging from 10 µm to 60 µm. For example, the first insulating layer 111, the second insulating layer 112, and the third insulating layer 113 may each have a thickness ranging from 12 µm to 40 µm. If the thickness of each of the first insulating layer 111, the second insulating layer 112, and the third insulating layer 113 is less than 5um, the circuit pattern included in the circuit board may not be stably protected. If the thickness of each of the first insulating layer 111, the second insulating layer 112, and the third insulating layer 113 exceeds 80um, an overall thickness of the circuit board may increase. In addition, if the thickness of each of the first insulating layer 111, the second insulating layer 112, and the third insulating layer 113 exceeds 80um, correspondingly, the thickness of the circuit pattern or through part increases, and the loss of signals transmitted through the circuit pattern may increase accordingly.

At this time, the thickness of the first insulating layer 111, the second insulating layer 112, and the third insulating layer 113 may correspond to a distance in the thickness direction between circuit patterns disposed at different layers.

For example, a thickness of the first insulating layer 111 may mean a straight line distance between a lower surface of the first circuit pattern 121 and an upper surface of the second circuit pattern 122. For example, the thickness of the second insulating layer 112 may mean the straight line distance between the lower surface of the second circuit pattern 122 and the third circuit pattern 123. For example, the thickness of the third insulating layer 113 may mean the straight line distance between the lower surface of the third circuit pattern 123 and the fourth circuit pattern 124.

Meanwhile, the first insulating layer 111 may be a first outermost insulating layer disposed at a first outermost side of the circuit board of the embodiment. For example, the first insulating layer 111 may be an uppermost insulating layer disposed at an uppermost side of the circuit board.

In addition, the third insulating layer 113 may be a second outermost insulating layer disposed at a second outermost side opposite to the first insulating layer 111 in the circuit board of the embodiment. For example, the third insulating layer 113 may be a lowermost insulating layer disposed at a lowermost side of the circuit board.

In addition, the second insulating layer 112 may be an inner insulating layer disposed between the first outermost insulating layer and the second outermost insulating layer. At this time, when the circuit board has a layer structure of four or more layers, the inner insulating layer may have a layer structure of two or more layers.

A circuit pattern is disposed on a surface of the insulating layer 110.

For example, the first circuit pattern 121 is disposed on an upper surface of the first insulating layer 111. For example, the second circuit pattern 122 is disposed on a lower surface of the first insulating layer 111 or an upper surface of the second insulating layer 112. For example, the third circuit pattern 123 is disposed on a lower surface of the second insulating layer 112 or an upper surface of the third insulating layer 113. For example, the fourth circuit pattern 124 is disposed on a lower surface of the third insulating layer 113.

In an embodiment, the circuit board may be manufactured using an Embedded Trace Substrate (ETS) method. Accordingly, at least one of the circuit patterns included in the circuit board may have an ETS structure. Here, having the ETS structure may mean having a structure in which the outermost circuit pattern disposed at the outermost portion is embedded in the outermost insulating layer. In other words, a cavity (C)oncave toward the lower side is formed on the upper surface of the uppermost insulating layer disposed on the uppermost side of the circuit board in the ETS structure, and accordingly, it may mean that the circuit pattern disposed on the uppermost side of the circuit board has a structure disposed on the cavity of the uppermost insulating layer.

For example, a circuit pattern disposed on at least one of the circuit patterns disposed on each layer of the circuit board may have a structure embedded in an insulating layer. For example, in an embodiment, the circuit pattern disposed on the upper surface of the first outermost insulating layer may have an ETS structure. For example, in an embodiment, the first circuit pattern 121 disposed on the upper surface of the first insulating layer 111 may have an ETS structure. However, the embodiment is not limited thereto, and the circuit pattern disposed on the lowermost side of the circuit board may have an ETS structure depending on the arrangement direction of the circuit board. Hereinafter, for convenience of description of the embodiment, a circuit pattern disposed on the uppermost side of the circuit board will be described as having an ETS structure.

The first circuit pattern 121 may have a structure embedded in the first insulating layer 111. Preferably, an entire region of the first circuit pattern 121 may have a structure embedded in the insulating layer 110. For example, the fact that the entire region of the first circuit pattern 121 has a structure embedded in the first insulating layer 111 may mean that an entire side surface 121S of the first circuit pattern 121 is covered with the first insulating layer 111. For example, the fact that the entire region of the first circuit pattern 121 has a structure embedded in the first insulating layer 111 may mean that a portion of the side surface 121S of the first circuit pattern 121 does not protrude on the upper surface 121T (preferably, an uppermost portion of the upper surface of the first insulating layer) of the first insulating layer 111.

In addition, the fact that the first circuit pattern 121 has an ETS structure may mean that at least a portion of the upper surface 121T of the first circuit pattern 121 does not overlap the upper surface 111T of the first insulating layer 111 in the vertical direction. However, the entire region of the upper surface 121T of the first circuit pattern 121 may not overlap in the vertical direction with the upper surface 111T of the first insulating layer 111, or differently, only some regions may not overlap in the vertical direction with the upper surface 111T of the first insulating layer 111. That is, in the process of forming the first insulating layer 111 on the first circuit pattern 121, at least a portion of the first insulating layer 111 may penetrate into the inside of the first circuit pattern 121. In this case, at least a portion of an edge region of the upper surface 121T of the first circuit pattern 121 may overlap the upper surface 111T of the first insulating layer 111 in the vertical direction.

In addition, an entire lower surface 121B of the first circuit pattern 121 may be covered by the first insulating layer 111.

For example, the upper surface 111T of the first insulating layer 111 may include a cavity (C) that is concave toward a lower surface 111B of the first insulating layer 111. At this time, a depth of the cavity (C) may be greater than a thickness of the first circuit pattern 121. Accordingly, at least a portion of an inner surface CS of the cavity (C) may not contact a side surface 121S of the first circuit pattern 121. For example, at least a portion of the inner surface CS of the cavity (C) contacts the side surface 121S of the first circuit pattern 121, and at least another portion of the inner surface CS of the cavity (C) may not contact the side surface 121S of the first circuit pattern 121.

At this time, the first insulating layer 111 includes an upper surface 111T and a lower surface 111B. In addition, the upper surface 111T of the first insulating layer 111 includes a cavity (C) concave toward the lower surface 111B. Additionally, the first circuit pattern 121 may be disposed in the cavity (C). For example, the cavity (C) may overlap the first circuit pattern 121 in the vertical direction.

Accordingly, the first insulating layer 111 may include an inner surface CS of the cavity (C) contacting a side surface 121S of the first circuit pattern 121, and a bottom surface CB of the cavity (C) that contacts the lower surface 121B of the first circuit pattern 121. Here, a centerline surface roughness (Ra) of the upper surface 111T, a centerline surface roughness (Ra) of the lower surface 111B, a centerline surface roughness (Ra) of the inner surface CS and a centerline surface roughness (Ra) of the bottom surface CB of the cavity (C) of the first insulating layer 111 may be different from each other. This will be explained in more detail below.

For example, the upper surface 111T of the first insulating layer 111 may have a first centerline surface roughness.

And, the inner surface CS of the cavity (C) of the first insulating layer 111 and the bottom surface CB of the cavity (C) may have a second centerline surface roughness different from the first centerline surface roughness of the upper surface 111T.

The first centerline surface roughness of the upper surface 111T of the first insulating layer 111 may satisfy the range of 0.01um to 0.5um. For example, the first centerline surface roughness of the upper surface 111T of the first insulating layer 111 may satisfy the range of 0.015 um to 0.4 um. For example, the first centerline surface roughness of the upper surface 111T of the first insulating layer 111 may satisfy the range of 0.02 um to 0.2 um.

If the first centerline surface roughness of the upper surface 111T of the first insulating layer 111 is less than 0.01um, the bonding force between the dry film and the seed layer of the first circuit pattern 121 decreases during the process of stacking the dry film for forming the first circuit pattern 121, as a result, physical reliability may decrease. In addition, if the first centerline surface roughness of the upper surface 111T of the first insulating layer 111 is greater than 0.5um, it may be difficult to form a fine circuit pattern with a line width and spacing of less than 10um as in the comparative example.

Specifically, the first centerline surface roughness of the upper surface 111T of the first insulating layer 111 may correspond to a centerline surface roughness of a seed layer for electrolytic plating of the first circuit pattern 121. For example, (a) of FIG. 3C shows the upper surface of the first insulating layer or the upper surface of the seed layer of the first circuit pattern in the comparative example, and (b) of FIG. 3C shows the upper surface of the first insulating layer or the upper surface of the seed layer of the first circuit pattern in an embodiment. Accordingly, if the surface roughness of the upper surface of the first insulating layer or the upper surface of the seed layer of the first circuit pattern has a centerline surface roughness (Ra1) exceeding 0.5um as in the comparative example, it may be difficult to form the first circuit pattern with a width and spacing of 10 µm or less. In contrast, the embodiment allows the upper surface of the first insulating layer or the upper surface of the seed layer of the first circuit pattern to have a centerline surface roughness (Ra2) of 0.5um or less, so that the width and spacing of the first circuit pattern 121 are within a range of 2 µm to 8 µm.

Meanwhile, the inner surface CS of the cavity (C) of the first insulating layer 111 and the bottom surface CB of the cavity (C) can have a centerline surface roughness (Ra) that is greater than the centerline surface (Ra) of the upper surface 111T of the first insulating layer 111.

That is, the inner surface CS and bottom surface CB of the cavity (C) of the first insulating layer 111 may be in contact with the side surface 121S and the lower surface 121B of the first circuit pattern 121. And, accordingly, the inner surface CS and bottom surface CB of the cavity (C) of the first insulating layer 111 may be same as the centerline surface roughness of the side surface 121S and the lower surface 121B of the first circuit pattern 121.

For example, the centerline surface roughness (Ra) of the inner surface (CS) of the cavity (C) of the first insulating layer 111 may be the same as the centerline surface roughness (Ra) of the side surface 121S of the first circuit pattern 121. In addition, the centerline surface roughness (Ra) of the bottom surface CB of the cavity (C) of the first insulating layer 111 may be the same as the centerline surface roughness (Ra) of the lower surface 121B of the first circuit pattern 121.

At this time, the first circuit pattern 121 is formed by electrolytic plating, and accordingly, the centerline surface roughness (Ra) of the first circuit pattern 121 may be greater than the centerline surface roughness (Ra) of the upper surface 111T of the first insulating layer 111. Furthermore, in order to improve the adhesion of the first circuit pattern 121 to the first insulating layer 111, a pretreatment (e.g., etching process) process is performed after the electrolytic plating process. Accordingly, each centerline surface roughness (Ra) of the inner surface CS of the cavity (C) of the first insulating layer 111, the bottom surface CB of cavity (C) of the first insulating layer 111, the side surface 121S of the first circuit pattern 121 and the lower surface 121B of the first circuit pattern 121 may be smaller than the centerline surface roughness (Ra) of the upper surface 111T of the first insulating layer 111.

Preferably, the side surface 121S and the lower surface 121B of the first circuit pattern 121 may have the same centerline surface roughness (Ra) by proceeding with the same pretreatment process. Accordingly, the inner surface CS and bottom surface CB of the cavity (C) may have the same centerline surface roughness (Ra).

Meanwhile, the upper surface 121T of the first circuit pattern 121 may be partially removed along with the seed layer during a process of removing of the seed layer after a process of manufacturing the circuit board. Accordingly, the centerline surface roughness (Ra) of the upper surface 121T of the first circuit pattern 121 may be different from the centerline surface roughness (Ra) of the side surface 121S of the first circuit pattern 121 and the centerline surface roughness (Ra) of the lower surface 121B of the first circuit pattern 121.

In addition, the upper surface 121T of the first circuit pattern 121 has a centerline surface roughness (Ra) corresponding to the centerline surface roughness (Ra) of the seed layer before the process of removing the seed layer, and accordingly, the upper surface 121T of the first circuit pattern 121 has the same centerline surface roughness (Ra) as the upper surface 111T of the first insulating layer 111. However, in the process of removing the seed layer, a portion of the first circuit pattern 121 is removed along with the seed layer, and accordingly, the centerline surface roughness (Ra) of the upper surface 121T of the first circuit pattern 121 in the finally manufactured circuit board may be different from the centerline surface roughness (Ra) of the upper surface 111T of the first insulating layer 111.

Meanwhile, the lower surface 111B of the first insulating layer 111 may have a centerline surface roughness (Ra) that is different from the centerline surface roughness (Ra) of the upper surface 111T of the first insulating layer 111. For example, the lower surface 111B of the first insulating layer 111 has a centerline surface roughness (Ra) corresponding to a copper foil layer or a seed layer formed by plating. For example, the second circuit pattern 122 formed on the lower surface 111B of the first insulating layer 111 does not require miniaturization unlike the first circuit pattern 121, and accordingly, the seed layer of the second circuit pattern 122 may be formed by plating. Accordingly, the lower surface 111B of the first insulating layer 111 may have a centerline surface roughness (Ra) greater than the centerline surface roughness (Ra) of the upper surface 111T of the first insulating layer 111. However, the embodiment is not limited thereto, and a centerline surface roughness (Ra) of the lower surface 111B of the first insulating layer 111 may be same as the centerline surface roughness (Ra) the upper surface of the first insulating layer 111.

Meanwhile, a step SP may be provided at the upper surface 111T of the first insulating layer 111. For example, the upper surface 111T of the first insulating layer 111 may have a curve. For example, a concave portion concave downward may be provided at the upper surface 111T of the first insulating layer 111. At this time, the cavity (C) is provided at the upper surface 111T of the first insulating layer 111 in a region that overlaps the first circuit pattern 121 in the vertical direction. Additionally, the concave portion corresponding to the step SP may be provided at a region of the upper surface 111T of the first insulating layer 111 that does not overlap the first circuit pattern 121 in the vertical direction.

For example, the first insulating layer 111 is partially removed in the process of removing the seed layer of the first circuit pattern 121, and accordingly, it may have a step, curve, or concave portion as shown in FIG. 3A.

Accordingly, the upper surface 111T of the first insulating layer 111 may include a first portion 111T1 positioned higher than the upper surface 121T of the first circuit pattern 121 and a second portion 111T2 positioned lower than the upper surface 121T of the first circuit pattern 121. Also, the first portion 111T1 and the second portion 111T2 of the upper surface 111T of the first insulating layer 111 may have a step SP of different heights. At this time, the first portion 111T1 of the upper surface 111T of the first insulating layer 111 may be positioned adjacent to the side surface 121S of the first circuit pattern 121 compared to the second portion 111T2. For example, the second portion 111T2 of the upper surface 111T of the first insulating layer 111 may be positioned farther from the side surface 121S of the first circuit pattern 121 compared to the first portion 111T1. Accordingly, the step SP of the upper surface 111T of the first insulating layer 111 may have a height that decreases as it moves away from the side surface 121S of the first circuit pattern 121.

Through this, the embodiment can improve the electrical reliability of the circuit board. Specifically, high integration of recent circuit boards is required, and accordingly, the line width and pitch of the first circuit pattern 121 are becoming finer. In this case, it may not be possible to place an insulating layer, such as a protective layer, on the circuit board. At this time, space for arrangement of a connection part (e.g., solder) for attachment of a chip or interposer may not be secured on the first circuit pattern 121. As a result, a short circuit problem may occur where neighboring circuit patterns are connected due to the flow of the connection part. In contrast, the embodiment may block the flow of the connection part by a second portion 111T2 of the upper surface 111T of the first insulating layer 111. Furthermore, the embodiment may increase a length of the upper surface 111T of the first insulating layer 111 by the second portion 111T2, as a result, even if the connection part flows, it can be prevented from contacting neighboring circuit patterns.

And, in an embodiment, the second circuit pattern 122, third circuit pattern 123, and fourth circuit pattern 124 excluding the first circuit pattern 121 may have a structure that protrudes from the surface of the insulating layer 110.

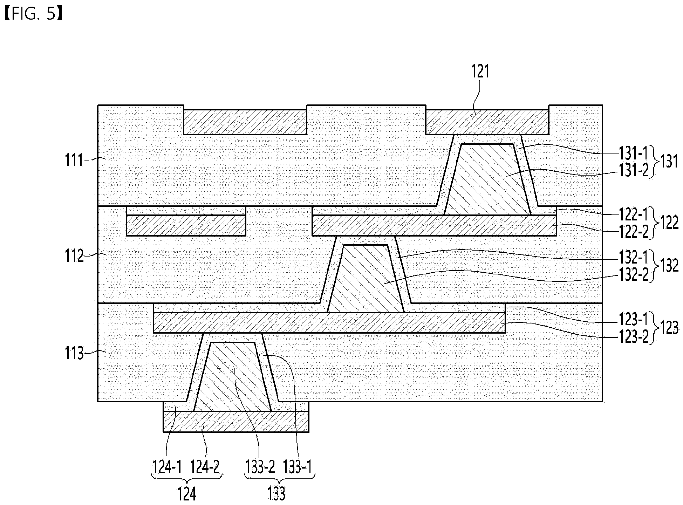

Meanwhile, as shown in FIG. 5, the first circuit pattern 121 may include a pad 121-1 and a trace 121-2 depending on a unction. The pad 121-1 may be a pad on which a chip is mounted or a pad coupled to an external substrate. The trace 121-2 may be a signal wiring line connecting a plurality of pads. The trace 121-2 is a fine pattern, and accordingly, the line width W1 between the plurality of traces ranges from 2um to 8um, and the spacing W2 of each trace may range from 2um to 8um. Specifically, in the embodiment, the line width and spacing of the traces 121-2 of the first circuit pattern 121 can be formed to be 8 µm or less, and this can be achieved by the centerline surface roughness (Ra) of the upper surface 111T of the first insulating layer 111. This means that the line width and spacing of the traces 121-2 of the first circuit pattern 121 can be formed to be 8 um or more, and the embodiment means that, unlike the comparative example, the line width and spacing can be formed to be smaller than 8um. Accordingly, the embodiment may allow the first circuit pattern 121 to be densely arranged in a narrow space through miniaturization of the first circuit pattern 121.

Meanwhile, the second circuit pattern 122 may be disposed on the lower surface of the first insulating layer 111. The second circuit pattern 122 may protrude below the first insulating layer 111. The side and lower surfaces of the second circuit pattern 122 may be covered with the second insulating layer 112.

For example, the third circuit pattern 123 may be disposed on the lower surface of the second insulating layer 112. The third circuit pattern 123 may protrude below the second insulating layer 112. For example, the side and lower surfaces of the third circuit pattern 123 may be covered with the third insulating layer 113.

For example, the fourth circuit pattern 124 may be disposed on the lower surface of the third insulating layer 113. The fourth circuit pattern 124 may protrude below the third insulating layer 113.

The circuit patterns as described above may be formed of at least one metal material selected from gold (Au), silver (Ag), platinum (Pt), titanium (Ti), tin (Sn), copper (Cu), and zinc (Zn). In addition, the circuit patterns may be formed of a paste or solder paste including at least one metal material selected from gold (Au), silver (Ag), platinum (Pt), titanium (Ti), tin (Sn), copper (Cu), and zinc (Zn) having excellent bonding power. Preferably, the first circuit pattern 121, the second circuit pattern 122, the third circuit pattern 123, and the fourth circuit pattern 124 may be formed of copper (Cu) having high electrical conductivity and a relatively inexpensive price.

Each of the first circuit pattern 121, the second circuit pattern 122, the third circuit pattern 123, and the fourth circuit pattern 124 may have a thickness in a range of 5 µm to 20 µm. For example, each of the first circuit pattern 121, the second circuit pattern 122, the third circuit pattern 123, and the fourth circuit pattern 124 may have a thickness in a range of 6 µm to 17 µm. Each of the first circuit pattern 121, the second circuit pattern 122, the third circuit pattern 123, and the fourth circuit pattern 124 may have a thickness in a range of 7 µm to 16 µm. When the thickness of each of the first circuit pattern 121, the second circuit pattern 122, the third circuit pattern 123, and the fourth circuit pattern 124 is less than 5 µm, the resistance of the circuit pattern may increase, and thus signal transmission efficiency may decrease. For example, when the thickness of the first circuit pattern 121 and the second circuit pattern 350 is less than 5 µm, signal transmission loss may increase. For example, when the thickness of each of the first circuit pattern 121, the second circuit pattern 122, the third circuit pattern 123, and the fourth circuit pattern 124 exceeds 20 µm, the line widths of the circuit patterns increase, and accordingly, the overall volume of the circuit board may increase.

The circuit board of the embodiment includes the through part.

The through part passes through the insulating layer 110 included in the circuit board, and thus may electrically connect circuit patterns disposed on different layers. At this time, the through part may be formed to penetrate only one insulating layer, or alternatively, may be formed to commonly penetrate at least two or more insulating layers.

For example, the circuit board includes a first through part 131. The first through part 131 may be formed to pass through the first insulating layer 111. The first through part 131 may electrically connect the first circuit pattern 121 and the second circuit pattern 122. For example, an upper surface of the first through part 131 may be directly connected to a lower surface of the first circuit pattern 121. For example, a lower surface of the first through part 131 may be directly connected to an upper surface of the second circuit pattern 122. Additionally, the first circuit pattern 121 and the second circuit pattern 122 may be electrically connected to each other through the first through part 131 to transmit signals.

For example, the circuit board includes a second through part 132. The second through part 132 may be formed to pass through the second insulating layer 112. The second through part 132 may electrically connect the second circuit pattern 122 and the third circuit pattern 123. For example, an upper surface of the second through part 132 may be directly connected to a lower surface of the second circuit pattern 122. For example, a lower surface of the second through part 132 may be directly connected to an upper surface of the third circuit pattern 123. Accordingly, the second circuit pattern 122 and the third circuit pattern 123 can be directly electrically connected to each other through the second through part 132 and transmit signals.

For example, the circuit board includes a third through part 133. The third through part 133 may be formed to pass through the third insulating layer 113. The third through part 133 may electrically connect the third circuit pattern 123 and the fourth circuit pattern 124. For example, an upper surface of the third through part 133 may be directly connected to a lower surface of the third circuit pattern 123. For example, a lower surface of the third through part 133 may be directly connected to an upper surface of the fourth circuit pattern 124. Accordingly, the third circuit pattern 123 and the fourth circuit pattern 124 may be electrically connected to each other and transmit signals.

The through part of the circuit board including the first through part 131, the second through part 132, and the third through part 133 as described above can be formed by forming a through hole passing through the insulating layer 110 and filling the inside of the formed through hole with a conductive material.

The through hole may be formed by any one of mechanical, laser, and chemical processing. When the via through is formed by machining, methods such as milling, drilling, and routing may be used, when formed by laser processing, a UV or CO2 laser method may be used, when formed by chemical, a chemical containing amino silane, ketones, or the like. Accordingly, at least one of plurality of insulating layers may be opened.

Meanwhile, the laser processing is a cutting method that concentrates optical energy on a surface to melt and evaporate a part of the material to take a desired shape, accordingly, complex formations by computer programs can be easily processed, and even composite materials that are difficult to cut by other methods can be processed.

In addition, the laser processing has a cutting diameter of at least 0.005mm, and has a wide range of possible thicknesses.

As the laser processing drill, it is preferable to use a YAG (Yttrium Aluminum Garnet) laser, a CO₂ laser, or an ultraviolet (UV) laser. YAG laser is a laser that can process both copper foil layers and insulating layers, and CO₂ laser is a laser that can process only insulating layers.

When the through hole is formed, the through part may be formed by filling the inside of the through hole with a conductive material. The metal material forming the through part may be any one material selected from copper (Cu), silver (Ag), tin (Sn), gold (Au), nickel (Ni), and palladium (Pd). In addition, the conductive material filling may use any one or a combination of electroless plating, electrolytic plating, screen printing, sputtering, evaporation, ink-jetting and dispensing.

Meanwhile, the circuit board of the embodiment may include a first protective layer 140 and a second protective layer 150. The first protective layer 140 and the second protective layer 150 may be disposed at outermost sides of the circuit pattern 121.

For example, the first protective layer 140 may be disposed at the first outermost or uppermost side of the circuit board. For example, the first protective layer 140 may be disposed on the upper surface of the first insulating layer 111. For example, the second protective layer 150 may be disposed at the second outermost or lowermost side of the circuit board. For example, the second protective layer 150 may be disposed on the lower surface of the third insulating layer 113.

The first protective layer 140 may include at least one opening (OR). For example, the first protective layer 140 may include an opening OR that overlaps the upper surface of the first circuit pattern 121 in a vertical direction. In addition, a connection part (for example, a solder ball) for chip mounting may be disposed on the upper surface of the first circuit pattern 121 that overlaps the opening OR of the first protective layer 140 in the vertical direction.

At this time, the lower surface of the first protective layer 140 may contact the upper surface 111T of the first insulating layer 111. Here, the embodiment allows the centerline surface roughness (Ra) of the upper surface 111T of the first insulating layer 111 to be 0.01 um to 0.5 um for miniaturization of the first circuit pattern 121. At this time, if the centerline surface roughness (Ra) of the upper surface 111T of the first insulating layer 111 is 0.01 um to 0.5um, although it is possible to miniaturize the first circuit pattern 121, there may be a problem in adhesion to the first protective layer 140. At this time, in the embodiment, the upper surface 111T of the first insulating layer 111 is provided with a concave portion such as a step SP. In addition, the first protective layer 140 may be formed by filling the concave portion of the step SP on the upper surface 111T of the first insulating layer 111. In addition, the concave portion such as the step SP can increase the contact area between the upper surface 111T of the first insulating layer 111 and the lower surface of the first protective layer 140, and accordingly, the adhesion between the first insulating layer 111 and the first protective layer 140 can be improved.

The second protective layer 150 may include at least one opening (not shown).

For example, the second protective layer 150 may have an opening that overlaps a lower surface of the fourth circuit pattern 124 in a vertical direction. For example, the second protective layer 150 may have an opening that overlaps in the vertical direction with a region of the lower surface of the fourth circuit pattern 124 (for example, a terminal pad portion connected to an external substrate) where solder balls will be placed later.

At this time, although not shown in the drawing, a surface treatment layer (not shown) may be disposed on the lower surface of the fourth circuit pattern 124 that overlaps the opening of the second protective layer 150 in the vertical direction. The surface treatment layer may be formed to improve soldering characteristics while preventing corrosion and oxidation of the fourth circuit pattern 124 exposed through the second protective layer 150.

The surface treatment layer may be an Organic Solderability Preservative (OSP) layer. For example, the surface treatment layer may be an organic layer formed of an organic material such as benzimidazole coated on the lower surface of the fourth circuit pattern 124.

However, the embodiment is not limited to this. For example, the surface treatment layer may be a plating layer. For example, the surface treatment layer may include at least one of a nickel (Ni) plating layer, a palladium (Pd) plating layer, and a gold (Au) plating layer. Additionally, the surface treatment layer may be exposed through the first protective layer 140 or may be formed on the upper surface of the first circuit pattern 121 where the first protective layer 140 is not disposed.

Meanwhile, as shown in FIG. 5, in an embodiment, the circuit pattern and through parts may have a multiple layer structure. However, in the embodiment, the first circuit pattern 121 of the circuit patterns has an ETS structure, and accordingly, a layer structure of the first circuit pattern 121 having the ETS structure may be different from a layer structure of other circuit patterns or through parts.

For example, a layer structure of the first circuit pattern 121 may be different from layer structures of the second circuit pattern 122, the third circuit pattern 123, and the fourth circuit pattern 124. For example, a number of layers of the first circuit pattern 121 may be smaller than a number of layers of each of the second circuit pattern 122, the third circuit pattern 123, and the fourth circuit pattern 124.

For example, the first circuit pattern 121 may include only an electrolytic plating layer. Alternatively, the second circuit pattern 122, the third circuit pattern 123, and the fourth circuit pattern 124 may each include a seed layer and an electrolytic plating layer. For example, the second circuit pattern 122 may include a seed layer 122-1 and an electrolytic plating layer 122-2. For example, the third circuit pattern 123 may include a seed layer 123-1 and an electrolytic plating layer 123-2. For example, the fourth circuit pattern 124 may include a seed layer 124-1 and an electrolytic plating layer 124. Correspondingly, the through part included in the circuit board may include a seed layer and an electrolytic plating layer. For example, the first through part 131 may include a seed layer 131-1 and an electrolytic plating layer 131-2. For example, the second through part 132 may include a seed layer 132-1 and an electrolytic plating layer 132-2. For example, the third through part 133 may include a seed layer 133-1 and an electrolytic plating layer 133-2.

The circuit board of the embodiment includes a first insulating layer and a first circuit pattern. The first insulating layer is an uppermost insulating layer, and the first circuit pattern is an uppermost circuit pattern disposed on an upper surface of the uppermost insulating layer. At this time, the first circuit pattern is embedded in the first insulating layer. For example, at least a portion of an upper surface of the first circuit pattern does not overlap an upper surface of the first insulating layer in the vertical direction. At this time, the upper surface of the first insulating layer in the embodiment has a centerline surface roughness (Ra) in a range of 0.01 um to 0.5um. And, the centerline surface roughness of the upper surface of the first insulating layer corresponds to a centerline surface roughness of a sputtering layer used as the seed layer of the first circuit pattern. At this time, if the centerline surface roughness (Ra) of the seed layer of the first circuit pattern exceeds 0.6um and the centerline surface roughness (Ra) of the upper surface of the first insulating layer accordingly exceeds 0.6um, there is a spaced portion between the dry film and the seed layer, and accordingly, it is difficult to refine a line width and spacing of the first circuit pattern to 10 µm or less. In contrast, the embodiment allows the centerline surface roughness (Ra) of the seed layer and the centerline surface roughness (Ra) of the upper surface of the first insulating layer to be in a range of 0.01um to 0.5um. Accordingly, the embodiment can increase a contact area between the seed layer and the dry film, thereby enabling miniaturization of the first circuit pattern. Accordingly, in the embodiment, the line width and spacing of the first circuit pattern can be formed to be 8um or less, and thus the circuit integration can be improved, and furthermore, a horizontal width and vertical thickness of the circuit board can be reduced.

Additionally, a step is formed at the upper surface of the first insulating layer in the embodiment. The step may be formed by removing a portion of the upper surface of the first insulating layer when removing the seed layer of the first circuit pattern. At this time, if the centerline surface roughness (Ra) of the upper surface of the first insulating layer is 0.5um or less, it is possible to miniaturize the first circuit pattern. However, it may cause problems with adhesion with the first protective layer, such as solder resist. Here, the embodiment forms a step such as a concave portion on the upper surface of the first insulating layer, and allows a first protective layer to fill the concave portion of the upper surface of the first insulating layer during formation of the first protective layer. Accordingly, the embodiment may increase a contact area between the upper surface of the first insulating layer and the lower surface of the first protective layer, and accordingly, the adhesion between the first insulating layer and the first protective layer can be improved.

In addition, the embodiment can improve the electrical reliability of the circuit board due to the step of the upper surface of the first insulating layer. Specifically, high integration of recent circuit boards is required, and accordingly, the line width and pitch of the first circuit pattern are becoming finer. In this case, it may not be possible to place an insulating layer, such as a protective layer, on the circuit board. At this time, space for arrangement of a connection part (e.g., solder) for attachment of a chip or interposer may not be secured on the first circuit pattern. As a result, a short circuit problem may occur where neighboring circuit patterns are connected due to the flow of the connection part. In contrast, the embodiment may block the flow of the connection part by a second portion of the upper surface of the first insulating layer. Furthermore, the embodiment may increase a length of the upper surface of the first insulating layer by the second portion, as a result, even if the connection part flows, it can be prevented from contacting neighboring circuit patterns.

### -Package Substrate-

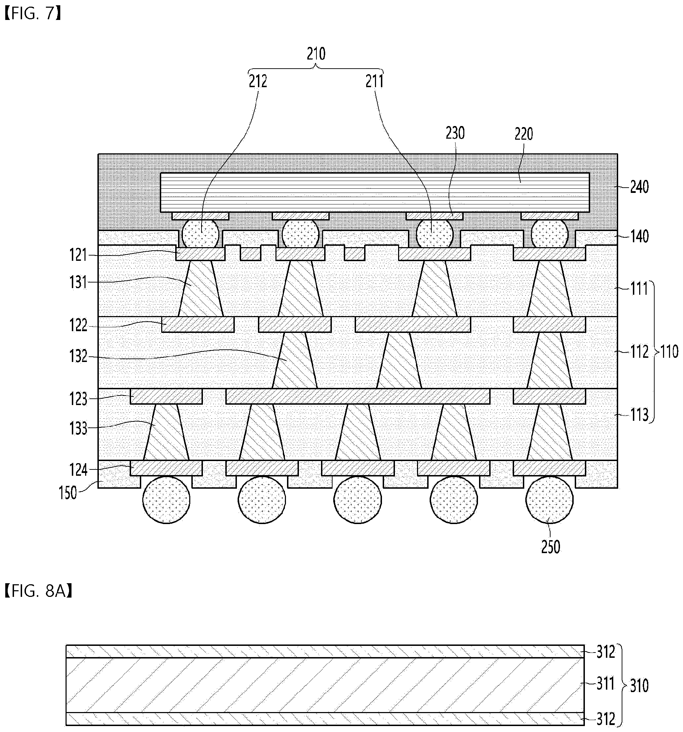

FIG. 7 is a view showing a package substrate according to an embodiment.

Referring to FIG. 7, a package substrate of the embodiment includes the circuit board shown in FIG. 2, at least one chip mounted on the circuit board, a molding layer for molding the chip, and a connection part for coupling the chip or external board. For example, the package substrate of FIG. 7 may represent a portion of the semiconductor package of FIGS. 2A to 2F.

Hereinafter, a package substrate including the circuit board of FIG. 3 will be described.

For example, the package substrate 200 includes a connection part 210 disposed on the first circuit pattern 121 disposed at an outermost side of the circuit board. The connection part 210 may be disposed on a plurality of pads of the circuit board. For example, the connection part 210 may include a first connection part 211 disposed on the first pad of the first circuit pattern 121 and a second connection part 212 disposed on the second pad disposed of the first circuit pattern 121.

The first connection part 211 and the second connection part 212 may have a hexahedral shape. For example, cross-sections of the first connection part 211 and the second connection part 212 may have a rectangular shape. The cross-sections of the first connection part 211 and the second connection part 212 may include a rectangular or square shape. For example, the first connection part 211 and the second connection part 212 may have a spherical shape. For example, the cross-sections of the first connection part 211 and the second connection part 212 may include a circular shape or a semicircular shape. For example, the cross-sections of the first connection part 211 and the second connection part 212 may include a partially or entirely rounded shape. The cross-sectional shape of the first connection part 211 and the second connection part 212 may be flat on one side and curved on the other side. The first connection part 211 and the second connection part 212 may be solder balls, but are not limited thereto.

Meanwhile, the embodiment may include a chip 220 disposed on the connection part 210. The chip 220 may be a processor chip. For example, the chip may be an application processor (AP) chip among a central processor (eg, CPU), a graphic processor (eg, GPU), a digital signal processor, an encryption processor, a microprocessor, and a microcontroller. A terminal 230 of the chip 220 may be connected to the first and second pads of the first circuit pattern 121 through the connection part 210.

In addition, although not shown in the drawing, the package substrate of the embodiment may further include an additional chip. For example, in an embodiment, at least two chips of a central processor (eg, CPU), a graphic processor (eg, GPU), a digital signal processor, an encryption processor, a microprocessor, and a microcontroller may be disposed on the circuit board at regular intervals. For example, the chip 220 in the embodiment may include a central processor chip and a graphic processor chip, but is not limited thereto.

Meanwhile, the plurality of chips may be spaced apart from each other by a predetermined interval on the circuit board. For example, the interval between the plurality of chips may be 150 µm or less. For example, the interval between the plurality of chips may be 120 µm or less. For example, the interval between the plurality of chips may be 100 µm or less.

Preferably, the interval between the plurality of chips may have a range of 60 µm to 150 µm. Preferably, the interval between the plurality of chips may have a range of 70 µm to 120 µm. Preferably, the interval between the plurality of chips may have a range of 80 µm to 110 µm. When the interval between the plurality of chips is less than 60 µm, a problem in operation reliability may occur due to interference between the plurality of chips. When the spacing between the plurality of chips is greater than 150 µm, as the distance between the plurality of chips increases, signal transmission loss may increase. When the spacing between the plurality of chips is greater than 150 µm, a volume of the package substrate 200 may increase.

The package substrate 200 may include a molding layer 240. The molding layer 240 may be disposed to cover the chip 220 . For example, the molding layer 240 may be EMC (Epoxy Mold Compound) formed to protect the mounted chip 220, but is not limited thereto.

At this time, the molding layer 240 may have a low dielectric constant to increase heat dissipation characteristics. For example, the dielectric constant (Dk) of the molding layer 240 may be 0.2 to 10. For example, the dielectric constant (Dk) of the molding layer 240 may be 0.5 to 8. For example, the dielectric constant (Dk) of the molding layer 240 may be 0.8 to 5. Accordingly, in the embodiment, the molding layer 250 has a low dielectric constant to improve heat dissipation characteristics for heat generated from the chip 220.

Meanwhile, the package substrate 200 may include a connection part 250 disposed at a lowermost side of the circuit board. The connection part 250 may be disposed on the lower surface of the fourth circuit pattern 124 exposed through the second protective layer 150.

### -Manufacturing method-

Hereinafter, the method of manufacturing a circuit board according to the first embodiment will be described in order of processes.

FIGS. 8A to 8M are views showing a method of manufacturing a circuit board shown in FIG. 3 in order of processes.

Referring to FIG. 8A, in the embodiment, a basic material for manufacturing a circuit board can be prepared using the ETS method.

For example, in an embodiment, a carrier board 310 may be prepared with a carrier insulating layer 311 and a metal layer 312 disposed on at least one surface of the carrier insulating layer 311. At this time, the metal layer 312 may be disposed on only one of first and second surfaces of the carrier insulating layer 311, or alternatively, may be disposed on both surfaces. For example, the metal layer 312 is disposed only on one surface of the carrier insulating layer 311, and accordingly, an ETS process for manufacturing a circuit board can be performed only on the one surface. Alternatively, the metal layer 312 may be disposed on both surfaces of the carrier insulating layer 311, and accordingly, the ETS process for manufacturing a circuit board can be performed simultaneously on both surfaces of the carrier board 311. In this case, two circuit boards can be manufactured at once.

At this time, the carrier insulating layer 311 and the metal layer 312 may be CCL (Copper Clad Laminate).

Meanwhile, hereinafter, a process of manufacturing the following circuit board is performed simultaneously on the metal layer 312 disposed on the upper and lower surfaces of the carrier insulating layer 311, and accordingly, two circuit boards can be manufactured simultaneously. However, the embodiment will describe manufacturing a circuit board only on the metal layer 312 disposed on the lower surface of the carrier insulating layer 311 for convenience of explanation,.

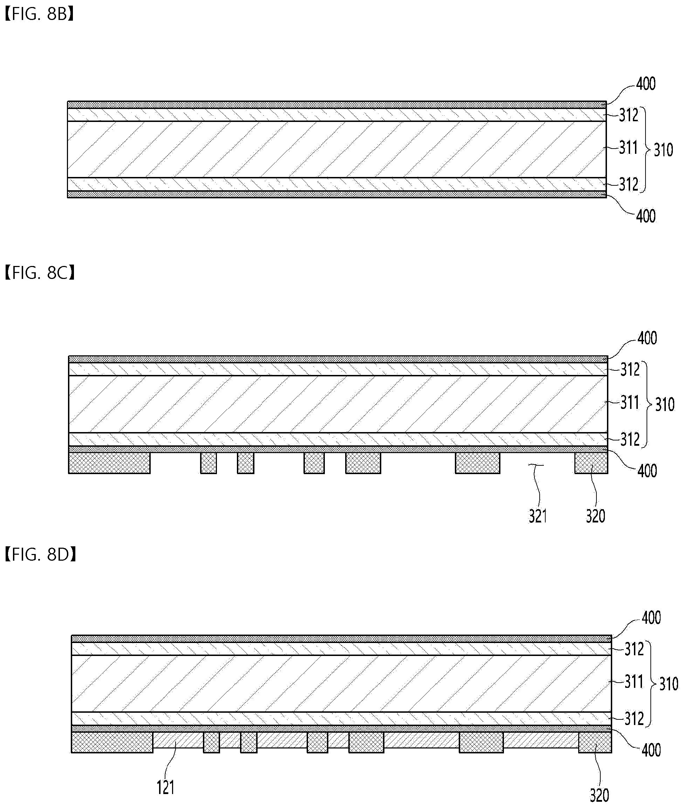

Next, referring to FIG. 8B, a sputtering layer 400 to be used as a seed layer for electrolytic plating of the first circuit pattern 121 is formed on a lower surface of the metal layer 312. The sputtering layer 400 may be formed on the metal layer 312 through a process of sputtering. When forming a metal layer through the process of sputtering, a thickness of the metal layer can be thinner compared to the metal layer formed by the chemical copper plating process, and the centerline surface roughness (Ra) of the metal layer can be lowered.

For example, in the case of a metal layer formed by a chemical copper plating process, a centerline surface roughness (Ra) exceeds 0.08um. In this case, there is a problem in that it is difficult to miniaturize the first circuit pattern, as described in FIGS. 1A and 1B.

In contrast, in the case of the metal layer (sputtering layer 400) formed by sputtering, the centerline surface roughness (Ra) is 0.05 µm or less. That is, in the case of the sputtering layer 400 formed by sputtering in the embodiment, the centerline surface roughness (Ra) may range from 0.01um to 0.5 um. In this case, in order to miniaturize the first circuit pattern 121, even if the separation distance between the openings of the dry film is 8um or less, the adhesion between the dry film and the sputtering layer 400 can be maintained.

Next, referring to FIG. 8C, in the embodiment, a first dry film 320 is formed on the sputtering layer 400. At this time, the first dry film 320 may be disposed to cover an entire lower surface of the sputtering layer 400. Next, the embodiment may proceed with a process of exposing and developing the formed first dry film 320.

Specifically, the embodiment can proceed with a process of forming an opening 321 that overlaps in the vertical direction with a region on the lower surface of the sputtering layer 400 where the first circuit pattern will be formed, by proceeding with the process of exposing and developing the first dry film 320.

At this time, the embodiment can proceed with a process of curing the first dry film 320 with the opening 321 formed through the exposure and development.

The process of curing the first dry film 320 may include a process of curing using ultraviolet rays and a process of curing using infrared rays.

For example, in an embodiment, the first dry film 320 may be cured using ultraviolet rays in a range of 5 mV to 100 mV. Alternatively, in an embodiment, the first dry film 320 may be cured by infrared heat curing.

As described above, the embodiment may further proceed with a process of curing the first dry film 320, so that adhesion between the sputtering layer 400 and the first dry film 320 can be improved. Accordingly, the embodiment can improve the adhesion between the first dry film 320 and the metal layer 312, and accordingly, the adhesion between the sputtering layer 400 and the first dry film 320 can be maintained, and thus the first circuit pattern 121 filling the opening 321 can be miniaturized. For example, in the embodiment, the line width and spacing of the traces of the first circuit pattern 121 can be reduced by additionally proceeding with the process of curing the first dry film 320. Furthermore, the embodiment may allow the spacing between the traces to be smaller than the line width of the trace of the first circuit pattern 121 by additionally proceeding with the process of curing the first dry film 320.

Next, referring to FIG. 8D, the embodiment can proceed with a process of forming the first circuit pattern 121 that fills the opening 321 of the cured first dry film 320 by performing electrolytic plating using the sputtering layer 400 as a seed layer.

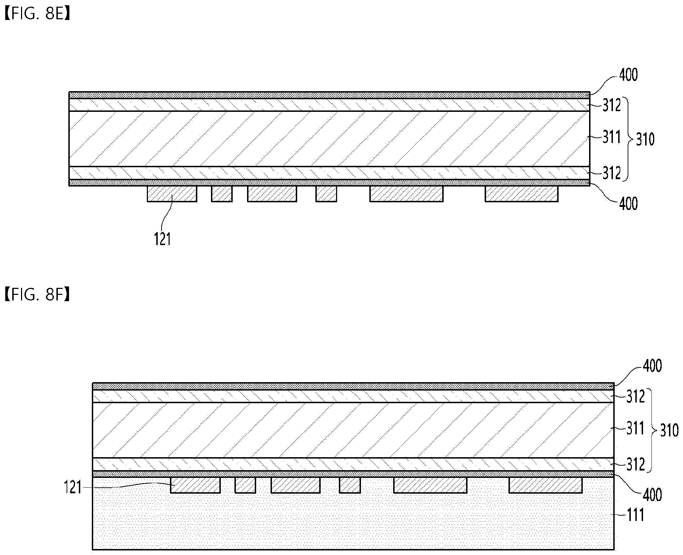

Next, referring to FIG. 8E, when plating of the first circuit pattern 121 is completed, the embodiment can proceed with a process of removing the first dry film 320 formed on the lower surface of the sputtering layer 400.

Next, referring to FIG. 8F, the embodiment can proceed with a process of forming a first insulating layer 111 covering the first circuit pattern 121 on the sputtering layer 400. At this time, the upper surface 111T of the first insulating layer 111 may directly contact the lower surface of the sputtering layer 400. Accordingly, the centerline surface roughness (Ra) of the upper surface 111T of the first insulating layer 111 may be the same as the centerline surface roughness (Ra) of the lower surface of the sputtering layer 400. For example, the upper surface of the first insulating layer 111 may have a centerline surface roughness (Ra) in a range of 0.01um to 0.5um.

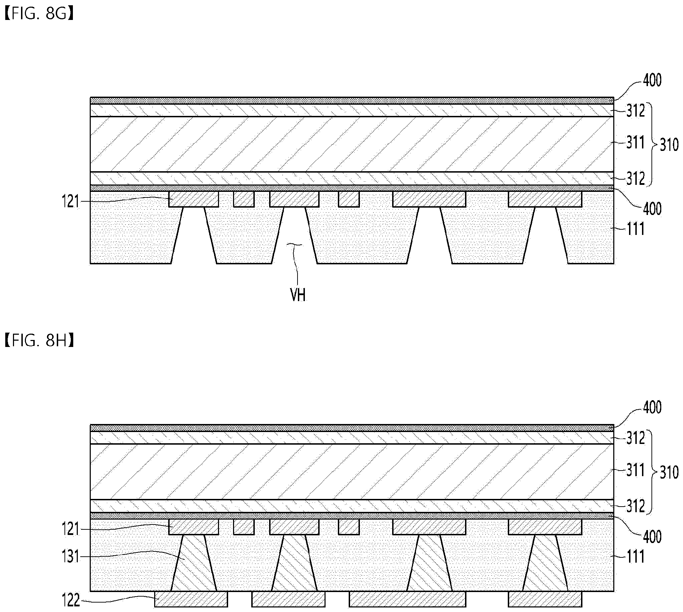

Next, referring to FIG. 8G, the embodiment can proceed with a process of forming a through hole (VH) in the first insulating layer 111. The through hole (VH) may be formed by laser processing, but is not limited thereto.

Next, referring to FIG. 8H, the embodiment can proceed with a process of forming the first through part 131 and the second circuit pattern 122.

Specifically, the embodiment can proceed with a process of forming a seed layer on the lower surface of the first insulating layer 111 and the inner wall of the through hole VH and a process of forming the second circuit pattern 122 and the first through part 131 by performing electrolytic plating using the seed layer.

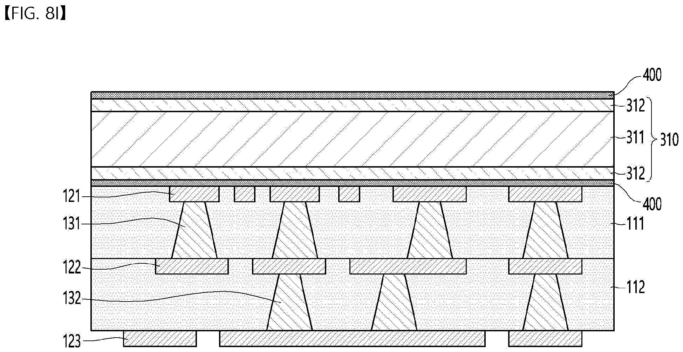

Next, referring to FIG. 8I, the embodiment can proceed with a stacking process by repeating the processes shown in FIGS. 8F to 8H.

Specifically, the embodiment can proceed with a process of forming a second insulating layer 112 covering the second circuit pattern 122 on the lower surface of the first insulating layer 111. Next, the embodiment can proceed with a process of forming a second through part 132 passing through the second insulating layer 112 and a third circuit pattern 123 protruding from the lower surface of the second insulating layer 112.

Next, referring to FIG. 8J, the embodiment can proceed with an additional stacking process by repeating the process shown in FIG. 8I.

Specifically, the embodiment can proceed with a process of forming a third insulating layer 113 covering the third circuit pattern 123 on the lower surface of the second insulating layer 112. Next, the embodiment can proceed with a process of forming a third through part 133 passing through the third insulating layer 113 and a fourth circuit pattern 124 protruding from the lower surface of the third insulating layer 113.

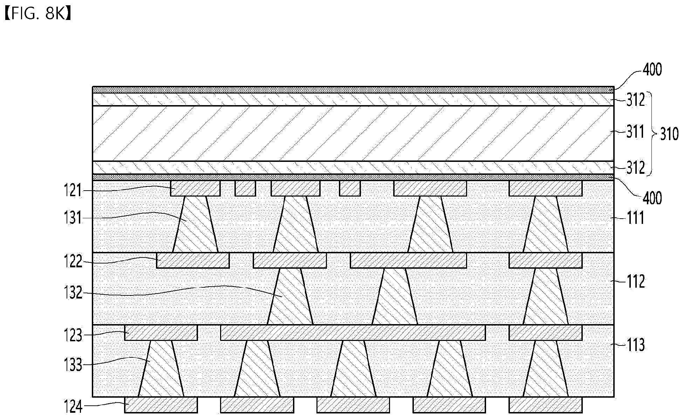

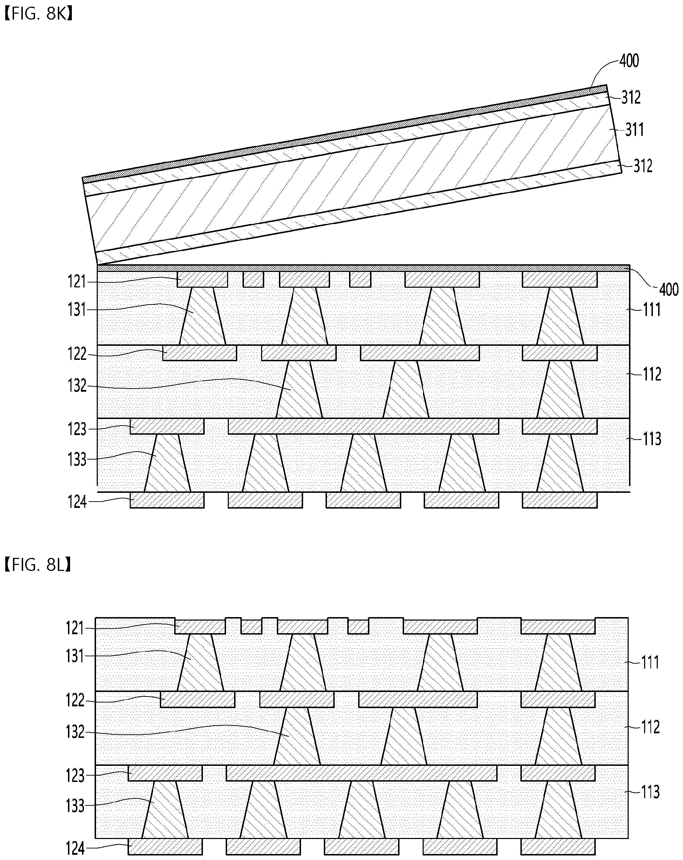

Next, referring to FIG. 8K, the embodiment can proceed with a process of removing the carrier board from the circuit board manufactured as described above. For example, the embodiment can proceed with a process of separating the carrier insulating layer 311 and the metal layer 312 based on an interface between the metal layer 312 of the carrier insulating layer 311 and the sputtering layer 400.

Next, referring to FIG. 8L, the embodiment can proceed with a process of etching and removing the sputtering layer 400 remaining on the upper surface of the first insulating layer 111 of the circuit board. Through this, the embodiment can proceed with a process of exposing the upper surface of the first insulating layer 111 disposed on the uppermost side of the circuit board.

At this time, in the process of removing the sputtering layer 400, a part of the upper surface 111T of the first insulating layer 111 and a part of the upper surface 111T of the first circuit pattern 121 can be also removed.

Accordingly, the upper surface of the first insulating layer 111 has a step SP including a first portion 111T1 and a second portion 111T2 having different heights.

In addition, the upper surface 111T of the first circuit pattern 121 may be positioned lower than the upper surface of the first insulating layer 111, preferably the first portion 111T1.

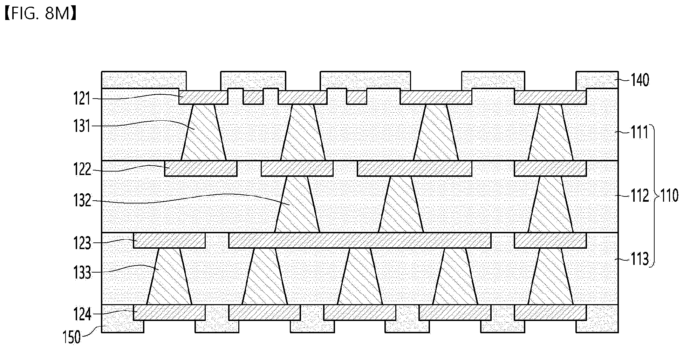

Next, referring to FIG. 8M, the embodiment may proceed with a process of forming a first protective layer 140 on the upper surface of the first insulating layer 111 and a process of forming a second protective layer 150 having an opening on the lower surface of the third insulating layer 113.

Hereinafter, a circuit board according to a second embodiment will be described.

At this time, an overall structure of the circuit board of a second embodiment is the same as that of the circuit board of the first embodiment shown in FIG. 3. Accordingly, hereinafter, the circuit board according to the second embodiment will be described using the same reference numerals as those in FIG. 3.

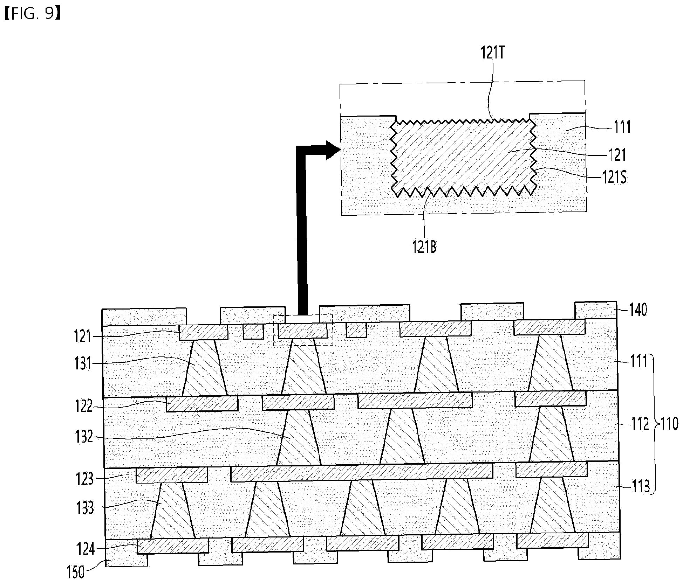

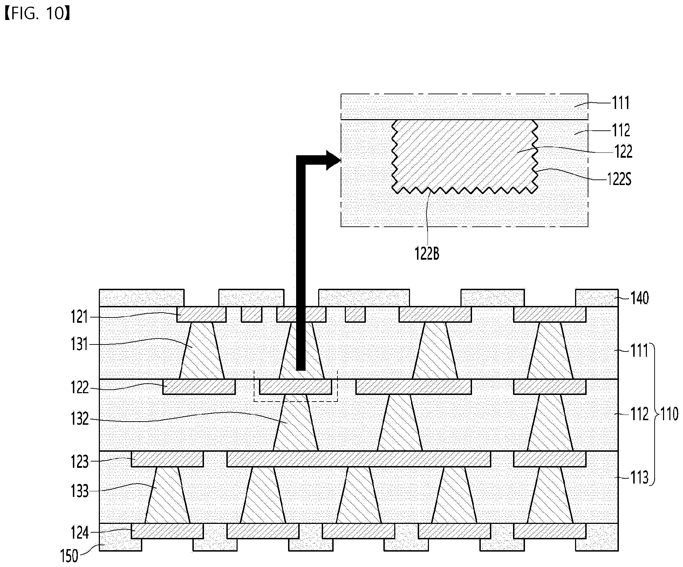

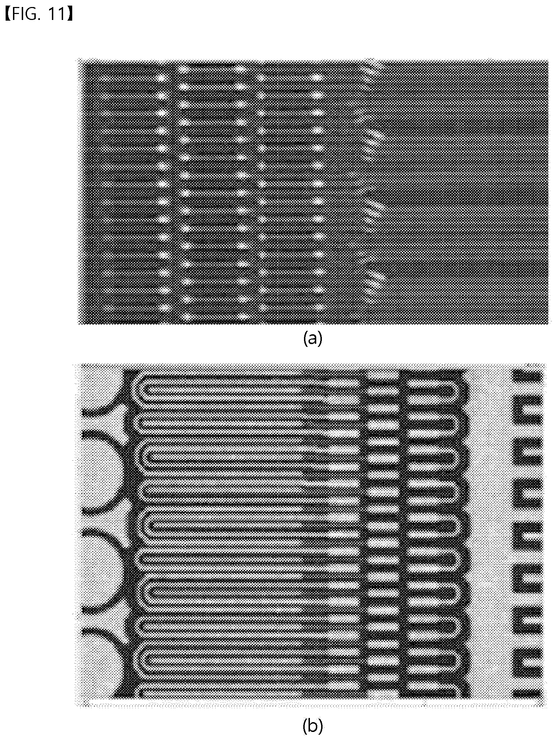

FIG. 9 is a view for explaining a surface roughness of a circuit board and a first circuit pattern according to a second embodiment, FIG. 10 is a view for explaining a surface roughness of an inner circuit pattern or a second circuit pattern of FIG. 9, and FIG. 11 is a view for explaining a process of soft etching a lower surface of a first circuit pattern according to an embodiment.

Hereinafter, the circuit board according to the second embodiment will be described in detail with reference to FIGS. 9 to 11.

Hereinafter, a detailed description of parts that are substantially the same as the circuit board of the first embodiment will be omitted.

At least part or all of the first circuit pattern 121 may have a structure embedded in the first insulating layer 111. For example, the first circuit pattern 121 may be an outermost circuit pattern or an uppermost circuit pattern disposed at an outermost side of the circuit board. Accordingly, at least a portion of a side surface 121S of the first circuit pattern 121 may be covered by the first insulating layer 111.

Meanwhile, an upper surface 121T of the first circuit pattern 121 may be positioned on the same plane as an upper surface of the first insulating layer 111. Alternatively, the upper surface 121T of the first circuit pattern 121 may be positioned lower than an upper surface of the first insulating layer 111. This is because, a portion of the first circuit pattern 121 may also be removed in a process of etching the seed layer (not shown) of the first circuit pattern 121.

The second circuit pattern 122 may be disposed at the lower surface of the first insulating layer 111. The second circuit pattern 122 may protrude below the first insulating layer 111. The side and lower surfaces of the second circuit pattern 122 may be covered with the second insulating layer 112.

For example, the third circuit pattern 123 may be disposed at the lower surface of the second insulating layer 112. The third circuit pattern 123 may protrude below the second insulating layer 112. For example, the side and lower surfaces of the third circuit pattern 123 may be covered with the third insulating layer 113.

For example, the fourth circuit pattern 124 may be disposed on the lower surface of the third insulating layer 113. The fourth circuit pattern 124 may protrude below the third insulating layer 113.

At this time, a certain level of surface roughness may be provided to the circuit pattern of the circuit board in the second embodiment.

In the second embodiment, the first circuit pattern 121 disposed on the uppermost side may include an upper surface 121T, a side surface 121S, and a lower surface 121B.

The upper surface 121T of the first circuit pattern 121 does not overlap an upper surface of the first insulating layer 111 in a vertical direction. For example, the upper surface 121T of the first circuit pattern 121 may be exposed to an upper side of the first insulating layer 111 when the first circuit pattern is disposed at the first insulating layer 111.

At this time, in the embodiment, the upper surface 121T, the side surface 121S, and the lower surface 121B of the first circuit pattern 121 may have different surface roughness. At this time, the surface roughness may be a centerline surface roughness (Ra), or alternatively, it may be a ten-point average roughness (Rz).

Here, in the circuit board in the comparative example, the upper surface of the first circuit pattern has a surface roughness different from the surface roughness of the side and lower surfaces of the first circuit pattern. However, in the circuit board in the comparative example, the side and lower surfaces of the first circuit pattern have the same surface roughness as each other. For example, the side and lower surfaces of the first circuit pattern are surfaces formed by plating, and they have substantially the same surface roughness as the same pretreatment process is performed after the plating process.

In contrast, the side surface 121S and the lower surface 121B of the first circuit pattern 121 in the embodiment may have different surface roughness. This is because at least two pretreatment processes are performed on the lower surface 121B of the first circuit pattern 121 in order to perform the AOI of the first circuit pattern 121, and a fewer number of pretreatment processes are performed on the side surface 121S of the first circuit pattern 121 than on the lower surface 121B.

Accordingly, in an embodiment, a surface roughness of the side surface 121S of the first circuit pattern 121 may be smaller than a surface roughness of the lower surface 121B of the first circuit pattern 121.

For example, at least one more pretreatment process is performed on the lower surface 121B of the first circuit pattern 121 than the pretreatment process on the side of the first circuit pattern 121, and accordingly, the first circuit pattern 121 may have a surface roughness greater than that of the side surface.

A side surface 121S of the first circuit pattern 121 may have a surface roughness greater than 0um. For example, the side surface 121S of the first circuit pattern 121 may have a centerline surface roughness (Ra) ranging from 0.05 µm to 0.6 µm. For example, the side surface 121S of the first circuit pattern 121 may have a centerline surface roughness (Ra) ranging from 0.08 um to 0.55 um. For example, the side surface 121S of the first circuit pattern 121 may have a centerline surface roughness (Ra) ranging from 0.1 µm to 0.45 µm. If the centerline surface roughness (Ra) of the side surface 121S of the first circuit pattern 121 is less than 0.05um, adhesion between the first insulating layer 111 and the side surface 121S of the first circuit pattern 121 may decrease. If the centerline surface roughness (Ra) of the side surface 121S of the first circuit pattern 121 is greater than 0.6um, transmission loss of a signal transmitted through the side surface 121S of the first circuit pattern 121 may increase. For example, high-frequency signals have the characteristic of moving along the surface of a circuit pattern due to the skin effect. At this time, if the surface roughness of the circuit pattern increases, resistance increases, and thus signal transmission loss due to the skin effect may increase.

The lower surface 121B of the first circuit pattern 121 may have a centerline surface roughness (Ra) greater than that of the side surface 121S of the first circuit pattern 121. This is because an additional pretreatment process was performed only on the lower surface 121B of the first circuit pattern 121 in order to perform an AOI on the first circuit pattern 121 after plating of the first circuit pattern 121 is completed in the manufacturing process of the first circuit pattern 121.

The lower surface 121B of the first circuit pattern 121 may have a centerline surface roughness greater than the centerline surface roughness (Ra) of the side surface 121S of the first circuit pattern 121 within the range of the centerline surface roughness (Ra) of the side surface 121S of the first circuit pattern 121.

For example, the centerline surface roughness (Ra) of the lower surface 121B of the first circuit pattern 121 may range between 110% and 170% of the centerline surface roughness (Ra) of the side surface 121S of the first circuit pattern 121. For example, the centerline surface roughness (Ra) of the lower surface 121B of the first circuit pattern 121 may range between 120% and 160% of the centerline surface roughness (Ra) of the side surface 121S of the first circuit pattern 121. For example, the centerline surface roughness (Ra) of the lower surface 121B of the first circuit pattern 121 may range between 125% and 150% of the centerline surface roughness (Ra) of the side surface 121S of the first circuit pattern 121.

If the centerline surface roughness (Ra) of the lower surface 121B of the first circuit pattern 121 is less than 110% of the centerline surface roughness (Ra) of the side surface 121S of the first circuit pattern 121, inspection accuracy may be lowered when performing an AOI of the lower surface 121B of the first circuit pattern 121. For example, in order to perform an AOI of the lower surface 121B of the first circuit pattern 121, the centerline surface roughness (Ra) of the lower surface 121B of the first circuit pattern 121 must be above a certain level. At this time, if the centerline surface roughness (Ra) of the lower surface 121B of the first circuit pattern 121 is less than 110% of the centerline surface roughness (Ra) of the side surface 121S of the first circuit pattern 121, this means that the lower surface 121B of the first circuit pattern 121 does not have a centerline surface roughness (Ra) at a level that allows the AOI to be performed when the AOI is performed, and accordingly, inspection accuracy for the first circuit pattern 121 may be lowered. For example, if the centerline surface roughness (Ra) of the lower surface 121B of the first circuit pattern 121 is less than 110% of the centerline surface roughness (Ra) of the side surface 121S of the first circuit pattern 121, this means that an oxide on the lower surface 121B of the first circuit pattern 121 was not completely removed during the AOI, as a result, inspection accuracy may decrease. For example, the side surface 121S of the first circuit pattern 121 is covered with a dry film (not shown) after the formation of the first circuit pattern 121 is completed, and a soft etching process may be performed on the lower surface 121B of the first circuit pattern 121.

For example, as shown in (a) of FIG. 11, when plating of the first circuit pattern 121 is completed in the forming process of the first circuit pattern 121, the side surface 121S and the lower surface 121B of the first circuit pattern 121 may have substantially the same centerline surface roughness (Ra). At this time, the lower surface 121B of the first circuit pattern 121 may have an oxide formed through a plating process. In addition, when the oxide is formed, AOI accuracy for the lower surface 121B of the first circuit pattern 121 may decrease. Furthermore, when the plating of the first circuit pattern 121 is completed, a centerline surface roughness (Ra) formed by the plating is not a centerline surface roughness (Ra) capable of AOI, and thus AOI accuracy may decrease.

Accordingly, the embodiment allows the soft etching process to be performed only on the lower surface 121B of the first circuit pattern 121 after the plating of the first circuit pattern 121 is completed, and accordingly, the centerline surface roughness (Ra) that allows AOI is provided to the lower surface 121B of the first circuit pattern 121 while removing the oxide film on the lower surface 121B of the first circuit pattern 121.

Accordingly, in the embodiment, the side surface 121S and the lower surface 121B of the first circuit pattern 121 have different centerline surface roughness (Ra).

Meanwhile, the upper surface 121T of the first circuit pattern 121 is etched together with the seed layer in an etching process to remove the seed layer used for plating the first circuit pattern 121, and accordingly, the centerline surface roughness (Ra) may be lower than that of the side surface 121S and the lower surface 121B of the first circuit pattern 121. At this time, in the process of etching the seed layer of the first circuit pattern 121, the side surfaces 121S and the lower surface 121B of the first circuit pattern 121 is covered with the first insulating layer 111 and is not etched.

Meanwhile, in an embodiment, side and lower surfaces of circuit patterns other than the first circuit pattern 121 may have the same centerline surface roughness (Ra).

For example, the side surface 122S and the lower surface 122B of the second circuit pattern 122 may have the same centerline surface roughness (Ra). This is because a process of removing the seed layer of the second circuit pattern 122 is performed before an additional insulating layer is laminated, and a soft etching process for the lower surface 121B of the first circuit pattern 121, such as the first circuit pattern 121, is unnecessary.

Accordingly, the side surface 122S and the lower surface 122B of the second circuit pattern 122 may have centerline surface roughness (Ra) corresponding to the side surface 121S of the first circuit pattern 121. The corresponding may mean that the centerline surface roughness (Ra) of the side surface 122S and lower surface 122B of the second circuit pattern 122 is the same as the centerline surface roughness (Ra) of the side surface 121S of the first circuit pattern 121. Unlike this, the corresponding may mean that the centerline surface roughness (Ra) of the side surface 122S and lower surface 122B of the second circuit pattern 122 has a range between 97% and 103% of the centerline surface roughness (Ra) of the side surface 121S of the first circuit pattern 121. That is, the corresponding means that the centerline surface roughness (Ra) of the side surface 122S and the lower surface 122B of the second circuit pattern 122 is the same as or has little difference with the centerline surface roughness (Ra) of the side surface 121S of the first circuit pattern 121.

As described above, the embodiment allows an additional pretreatment process (e.g., soft etching process) to be performed only on the lower surface 121B of the first circuit pattern 121 through the ETS method after the first circuit pattern 121 is formed, and accordingly, AOI of the lower surface of the first circuit pattern 121 is possible. Accordingly, the side surface 121S and the lower surface 121B of the first circuit pattern 121 in the embodiment may have different centerline surface roughness (Ra).

In addition, in an embodiment, the second circuit pattern 122 other than the first circuit pattern 121 does not require a soft etching process, unlike the first circuit pattern 121. Accordingly, unlike the first circuit pattern 121, the side surface 122S of the second circuit pattern 122 and the lower surface 122B of the second circuit pattern 122 may have the same centerline surface roughness (Ra).

The circuit board in the embodiment is disposed on the uppermost side and includes a first circuit pattern buried in the insulating layer. At this time, the first circuit pattern includes an upper surface, a side surface, and a lower surface. Additionally, the side and lower surfaces of the first circuit pattern may be covered by the insulating layer. In addition, the side and lower surfaces of the first circuit pattern in the embodiment may have different centerline surface roughness (Ra). For example, the lower surface of the first circuit pattern may have a centerline surface roughness (Ra) greater than a centerline surface roughness of the side surface of the first circuit pattern. This may be due to an additional soft etching process performed during the forming process of the first circuit pattern to perform an AOI on the lower surface of the first circuit pattern. Accordingly, the embodiment may allow AOI to be performed on the lower surface of the first circuit pattern before the seed layer of the first circuit pattern is removed and after the first circuit pattern is formed. Accordingly, the AOI accuracy of the first circuit pattern can be improved and inspection efficiency can be improved.

Hereinafter, a method of manufacturing a circuit board and a method of inspecting the circuit board according to the second embodiment will be described. Specifically, hereinafter, the method of manufacturing the circuit board shown in FIG. 9 will be described in order of processes.

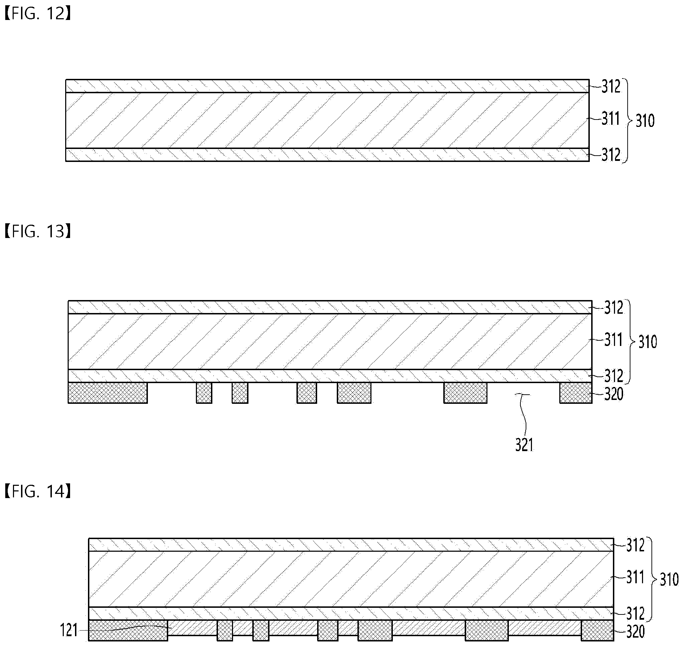

FIGS. 12 to 25 are views showing a method of manufacturing the circuit board shown in FIG. 9 in order of processes.

Referring to FIG. 12, in the embodiment, a basic material for manufacturing a circuit board can be prepared using the ETS method.

For example, in an embodiment, a carrier board 310 may be prepared with a carrier insulating layer 311 and a metal layer 312 disposed on at least one surface of the carrier insulating layer 311. At this time, the metal layer 312 may be disposed on only one of first and second surfaces of the carrier insulating layer 311, or alternatively, may be disposed on both surfaces. For example, the metal layer 312 is disposed only on one surface of the carrier insulating layer 311, and accordingly, an ETS process for manufacturing a circuit board can be performed only on the one surface. Alternatively, the metal layer 312 may be disposed on both surfaces of the carrier insulating layer 311, and accordingly, the ETS process for manufacturing a circuit board can be performed simultaneously on both surfaces of the carrier board 311. In this case, two circuit boards can be manufactured at once.

The metal layer 312 may be formed by electroless plating on the carrier insulating layer 311. Unlike this, the carrier insulating layer 311 and the metal layer 312 may be CCL (Copper Clad Laminate).

Next, referring to FIG. 13, the embodiment proceeds with a process of forming a first dry film 320 on the metal layer 312. At this time, the first dry film 320 may be disposed to entirely cover the metal layer 312. Next, the embodiment may proceed with a process of exposing and developing the formed first dry film 320.

Specifically, the embodiment can proceed with a process of forming an opening 321 that overlaps in the vertical direction with a region where the first circuit pattern 121 is to be formed among the surface of the metal layer 312, by performing a process of exposing and developing the first dry film 320.

The opening 321 may be formed on a surface of the metal layer 312 to correspond to a region where the first circuit pattern 121 will be formed.

At this time, the embodiment may proceed with a process of curing the first dry film 320 in which the opening 321 is formed through the exposure and development.

The process of curing the first dry film 320 may include a process of curing using ultraviolet rays and a process of curing using infrared rays.

For example, in the embodiment, the first dry film 320 may be cured using ultraviolet rays in the range of 5 mV to 100 mV. Alternatively, the embodiment may perform infrared heat curing of the first dry film 320.

As described above, the embodiment further proceeds with a process of curing the first dry film 320, so that the adhesion between the metal layer 312 and the first dry film 320 can be improved. Accordingly, the embodiment can improve the bonding strength between the first dry film 320 and the metal layer 312, and it is possible to miniaturize the first circuit pattern 121 formed in the opening 321. For example, the embodiment may further proceed with a process of curing the first dry film 320 to reduce the line width and spacing of the traces of the first circuit pattern 121. Furthermore, the embodiment may further proceed with a process of curing the first dry film 320 to allow the spacing between the traces of the first circuit pattern 121 to be smaller than the line width of the trace.

Next, referring to FIG. 14, the embodiment may proceed with a process of forming the first circuit pattern 121 by forming a plating layer in the opening 321 of the cured first dry film 320 using the metal layer 312 as a seed layer.

Thereafter, in the embodiment, the first dry film 320 is not removed immediately after the first circuit pattern 121 is formed. Accordingly, in the embodiment, AOI of the first circuit pattern 121 is performed while the first dry film 320 is laminated.

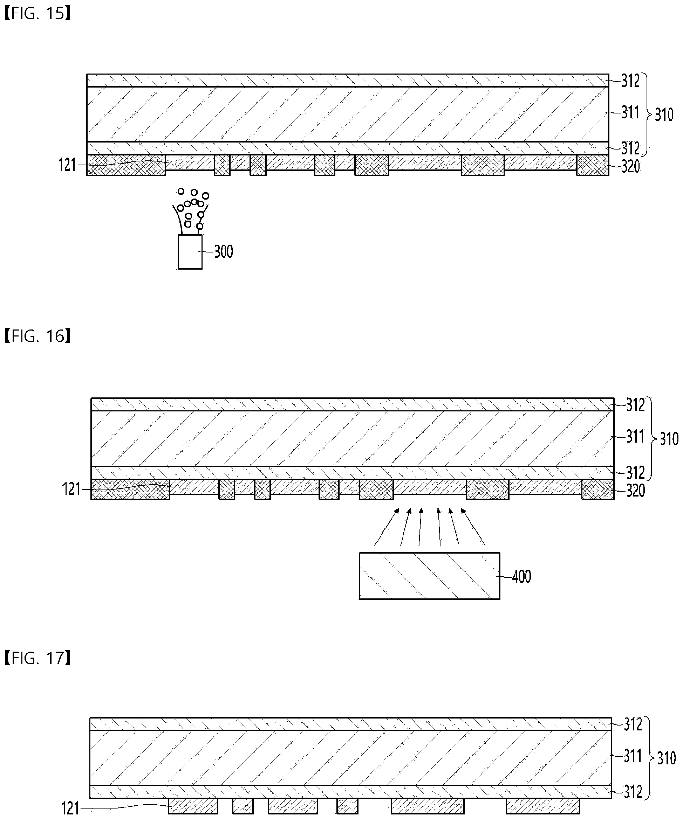

For this, referring to FIG. 15, in an embodiment, a soft etching process may be performed on the lower surface 121B of the first circuit pattern 121 that overlaps the first dry film 320 in the vertical direction using a soft etching device 300. Through this, after the soft etching process proceeds, the side surface 121S of the first circuit pattern 121 covered by the first dry film 320 and the lower surface of the first circuit pattern 121 have different centerline surface roughness (Ra).

A certain level of centerline surface roughness (Ra) is imparted to the lower surface 121B of the first circuit pattern 121 through the soft etching process, so that an oxide formed on the surface can be removed.

Through this, referring to FIG. 16, the embodiment may proceed AOI on the lower surface 121B of the soft-etched first circuit pattern 121 using the AOI equipment 400 while the first dry film 320 is disposed.

Next, when the AOI is completed, a process of removing the first dry film 320 can be performed, as shown in FIG. 17.

Next, the embodiment may proceed with a pretreatment process for the side surface 121S and the lower surface 121B of the first circuit pattern 121.

At this time, the side surface 121S and the lower surface (121B) of the first circuit pattern 121 before the pretreatment process have different centerline surface roughness (Ra), and the side surface 121S and the lower surface 121B of the first circuit pattern 121 after the pretreatment process have different centerline surface roughness (Ra).

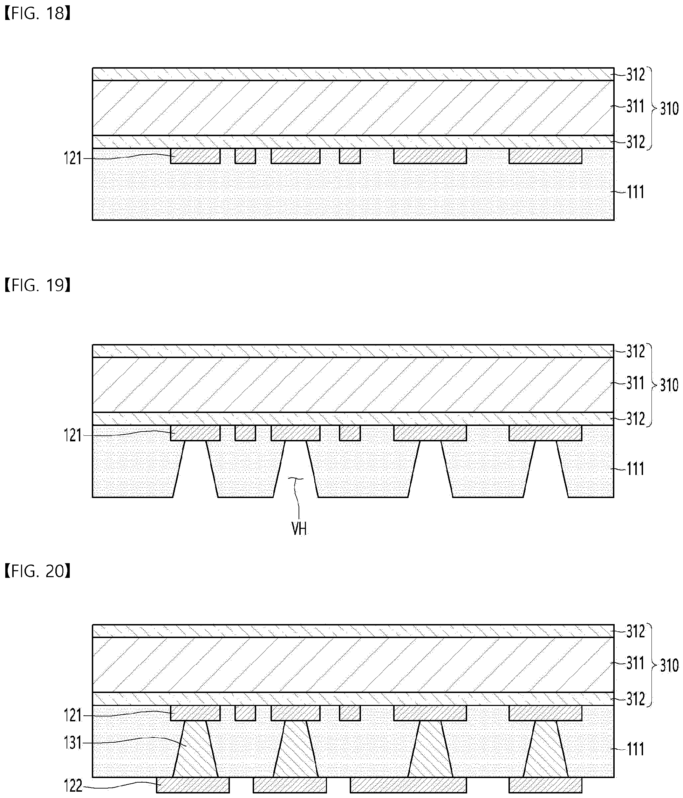

Next, in the embodiment, as shown in FIG. 18, a first insulating layer 111 covering the first circuit pattern 121 may be formed on the metal layer 312.

Next, referring to FIG. 19, the embodiment may proceed with a process of forming a through hole VH in the first insulating layer 111. The through hole (VH) may be formed by laser processing, but is not limited thereto.

Next, referring to FIG. 20, the embodiment may proceed with a process of forming the first through part 131 and the second circuit pattern 122.

Specifically, the embodiment may proceed with a process of forming a seed layer on the lower surface of the first insulating layer 111 and the inner wall of the through hole VH and a process of forming the second circuit pattern 122 and the first through part 131 by performing electrolytic plating using the seed layer.

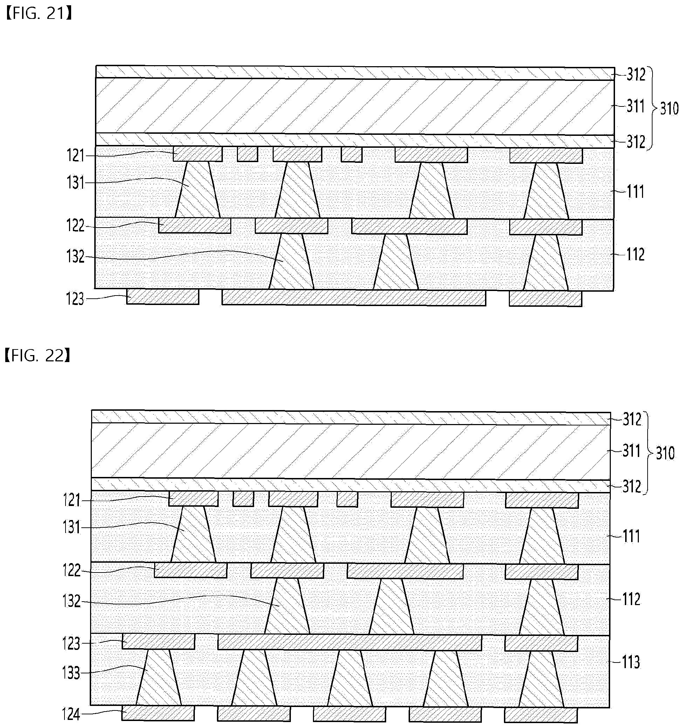

Next, as shown in FIG. 21, in the embodiment, a stacking process may be performed by repeating the processes shown in FIGS. 18 to 20.

Specifically, the embodiment may proceed with a process of forming a second insulating layer 112 covering the second circuit pattern 122 on the lower surface of the first insulating layer 111. Next, the embodiment may proceed with a process of forming a second through part 132 penetrating the second insulating layer 112 and a process of forming a third circuit pattern 123 protruding from the lower surface of the second insulating layer 112.

Next, as shown in FIG. 22, in the embodiment, an additional stacking process may be performed by repeating the process shown in FIG. 21.

Specifically, the embodiment may proceed with a process of forming a third insulating layer 113 covering the third circuit pattern 123 on the lower surface of the second insulating layer 112. Next, the embodiment may proceed with a process of forming a third through part 133 passing through the third insulating layer 113 and a process of forming a fourth circuit pattern 124 protruding from the lower surface of the third insulating layer 113.

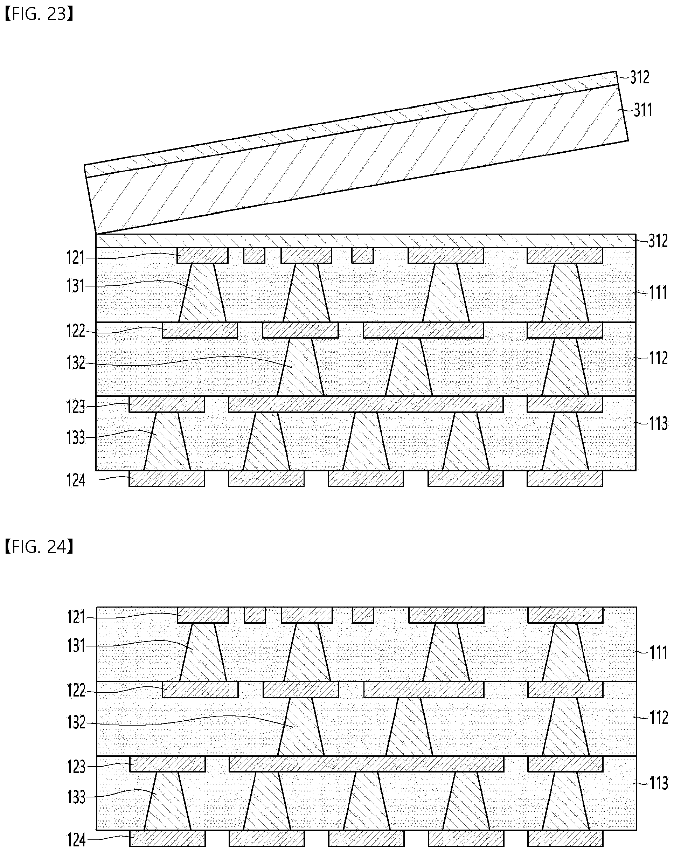

Next, as shown in FIG. 23, the embodiment may proceed with a process of removing the carrier board from the circuit board manufactured as described above. For example, a process may be performed to separate the carrier insulating layer 311 and the metal layer 312 of the carrier board 310 from each other.

Next, as shown in FIG. 24, the embodiment may proceed with a process of etching and removing the metal layer 312 remaining on the upper surface of the first insulating layer 111 of the circuit board. Through this, the embodiment may allow the upper surface of the first insulating layer 111 disposed on the uppermost side of the circuit board to be exposed.

At this time, the upper surface of the first insulating layer 111 after the metal layer 312 is removed may be located on the same plane as the upper surface 121T of the first circuit pattern 121.

In contrast, the upper surface of the first insulating layer 111 after the metal layer 312 is removed may be located higher than the upper surface 121T of the first circuit pattern 121.

At this time, part of the first circuit pattern 121 may be removed together when removing the metal layer 312, so that the upper surface 121T of the first circuit pattern 121 has a lower centerline surface roughness (Ra) than the side surface 121S and the lower surface 121B of the first circuit pattern 121.

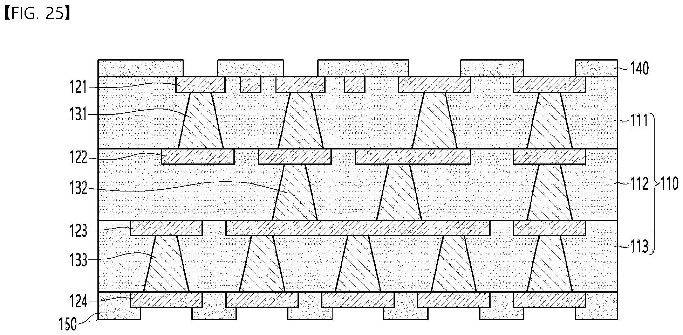

Next, as shown in FIG. 25, the embodiment may proceed with a process of forming a first protective layer 140 on the upper surface of the first insulating layer 111, and a process of forming a second protective layer 150 having an opening on the lower surface of the third insulating layer 113.

Features, structures, effects, etc. described in the above embodiments are included in at least one embodiment, and it is not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and variations should be interpreted as being included in the scope of the embodiments.

In the above, the embodiment has been mainly described, but this is only an example and does not limit the embodiment, and those of ordinary skill in the art to which the embodiment pertains will appreciate that various modifications and applications not illustrated above are possible without departing from the essential characteristics of the present embodiment. For example, each component specifically shown in the embodiment can be implemented by modification. And the differences related to these modifications and applications should be interpreted as being included in the scope of the embodiments set forth in the appended claims.

## Claims

1. A circuit board comprising:
a first insulating layer including an upper and lower surface; and
a first circuit pattern embedded at the upper surface of the first insulating layer,
wherein the upper surface of the first insulating layer includes a portion that does not overlap the first circuit pattern in a vertical direction, and
wherein the portion of the upper surface of the first insulating layer has a step.

2. The circuit board of claim 1, wherein the portion of the first insulating layer includes a concave portion whose height decreases as it moves away from the first circuit pattern along a horizontal direction.

3. The circuit board of claim 1, wherein at least a portion of the first insulating layer is located higher than an upper surface of the first circuit pattern.

4. The circuit board of claim 1, wherein a centerline surface roughness (Ra) of the upper surface of the first insulating layer is different from a centerline surface roughness (Ra) of an upper surface of the first circuit pattern.

5. The circuit board of claim 4, wherein the centerline surface roughness (Ra) of the upper surface of the first insulating layer ranges between 0.01um and 0.5um.

6. The circuit board of claim 4, wherein the first insulating layer is an uppermost insulating layer disposed on an uppermost side among a plurality of insulating layers, and
wherein at least a portion of the upper surface of the first circuit pattern does not overlap in a vertical direction with the upper surface of the first insulating layer.

7. The circuit board of claim 4, wherein the first insulating layer includes a cavity that overlaps the first circuit pattern in a vertical direction,
wherein the cavity includes:
an inner surface in contact with a side surface of the first circuit pattern, and
a bottom surface in contact with a lower surface of the first circuit pattern,
wherein a centerline surface roughness (Ra) of the upper surface of the first insulating layer is different from a centerline surface roughness (Ra) of the inner surface of the cavity and a centerline surface roughness (Ra) of the bottom surface of the cavity.

8. The circuit board of claim 7, wherein the centerline surface roughness (Ra) of the inner surface of the cavity is the same as the centerline surface roughness (Ra) of the bottom surface of the cavity.

9. The circuit board of claim 7, wherein the centerline surface roughness (Ra) of the upper surface of the first insulating layer is smaller than the centerline surface roughness (Ra) of the inner surface of the cavity and the centerline surface roughness (Ra) of the bottom surface of the cavity.

10. The circuit board of claim 4, wherein a centerline surface roughness (Ra) of the upper surface of the first insulating layer is smaller than a centerline surface roughness (Ra) of a lower surface of the first insulating layer.
